# EUROPEAN PATENT SPECIFICATION

(11) **EP 4 509 946 B1**
(45) Date of publication and mention of the grant of the patent: **11.03.2026**
(21) Application number: 24718021.9
(22) Date of filing: 22.03.2024
(51) Int. Cl.: G06F 1/16, H04M 1/02

(54) **HINGE ASSEMBLY AND ELECTRONIC DEVICE COMPRISING SAME**
SCHARNIERANORDNUNG UND ELEKTRONISCHE VORRICHTUNG DAMIT
ENSEMBLE CHARNIÈRE ET DISPOSITIF ÉLECTRONIQUE LE COMPRENANT

(30) Priority: 26.06.2023 KR 20230081818; 19.07.2023 KR 20230093967
(43) Date of publication of application: 19.02.2025
(73) Proprietor: Samsung Electronics Co., Ltd., Suwon-si, Gyeonggi-do 16677 (KR)
(72) Inventor: KIM, Jinwoo, Suwon-si, Gyeonggi-do 16677 (KR); CHO, Chongkun, Suwon-si, Gyeonggi-do 16677 (KR); JEONG, Uyhyeon, Suwon-si, Gyeonggi-do 16677 (KR)
(74) Representative: Gulde & Partner
(86) International application number: PCT/KR2024/003595
(87) International publication number: WO 2025/005394

(56) References cited:
- JP-A- 2014 192 398
- KR-A- 20100 020 133
- KR-A- 20220 038 036
- KR-A- 20220 168 295
- KR-A- 20230 022 769
- US-A1- 2022 217 859

## Description

### BACKGROUND

### 1. Field

The disclosure relates to a hinge assembly and an electronic device including the hinge assembly.

### 2. Description of Related Art

Recent advancements in display technology have led to the development of electronic devices equipped with flexible displays. A flexible display may be used in the form of a flat surface and may also be transformed into a specific shape. For example, an electronic device with a flexible display may be implemented to be folded or unfolded about at least one folding axis.

A conventional device is disclosed in US 2022/0217859 A1.

### SUMMARY

The invention is defined by the appended claims. Any disclosure lying outside the scope of said claims is only intended for illustrative as well as comparative purposes.

According to an embodiment, an electronic device includes a display including a first area, a second area, and a folding area between the first area and the second area, a first housing configured to support the first area, a second housing configured to support the second area, and a hinge assembly configured to connect the first housing to the second housing and operate between a folded state and an unfolded state, in which the first area and the second area face each other in the folded state and the first area and the second area do not face each other in the unfolded state. The hinge assembly may include a hinge bracket, a shaft rotatably connected to the hinge bracket, an arm member connected to the shaft to rotate integrally with the shaft with respect to the hinge bracket, a cam member inserted into the shaft such that cam interoperation between the arm member and the cam member is implemented, a pressing member configured to apply pressure to the cam member toward the arm member, and an arm bracket slidably connected to the arm member and connected to the first housing or the second housing. The arm member may include a cam portion on which a plurality of cam crests is formed along a circumference of a through hole through which the shaft passes, a body portion to which the arm bracket is slidably connected, and a connecting portion configured to connect the cam portion to the body portion. At least a partial area of a first cam crest among the plurality of cam crests may be positioned to be aligned with the connecting portion when viewed in a direction perpendicular to an axis of the shaft.

According to an embodiment, an electronic device includes a housing including a first housing and a second housing, a display accommodated in the first housing and the second housing, and a hinge assembly positioned on one surface of the display and connected to the first housing and the second housing. The hinge assembly may include a wing member configured to rotate around a first axis A1 and an arm member configured to rotate around a second axis A2 that is different from the first axis. The arm member may include a body portion, a cam portion on which a cam crest is formed on a surface facing a direction parallel to the second axis A2, and a connecting portion positioned between the body portion and the cam portion and having a thickness less than a thickness of the body portion and a thickness of the cam portion. The cam crest may be positioned to be aligned with the connecting portion in a direction perpendicular to the second axis in an area adjacent to the connecting portion within the surface of the cam portion.

According to an embodiment, a width of a connecting portion may be increased by forming at least one cam crest of a plurality of cam crests and the connecting portion to overlap or be aligned with each other. Therefore, the strength of the connecting portion may be enhanced. It may be possible to reduce the occurrence of damage to an arm member while achieving miniaturization of a hinge assembly and/or an electronic device.

The effects of a hinge assembly and an electronic device including the hinge assembly according to an embodiment are not limited to the above-mentioned effects, and other unmentioned effects may be clearly understood from the following description by one of ordinary skill in the art.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram illustrating an electronic device in a network environment, according to an embodiment;
FIG. 2A is a diagram illustrating an unfolded state of an electronic device according to an embodiment;
FIG. 2B is a diagram illustrating a folded state of the electronic device according to an embodiment;
FIG. 2C is a perspective view illustrating a fully unfolded state of the electronic device according to an embodiment;
FIG. 2D is a perspective view illustrating an example of a partially unfolded intermediate state of the electronic device according to an embodiment;
FIG. 3 is a front view illustrating a state in which a hinge assembly is applied to an electronic device according to an embodiment;
FIG. 4 is a perspective view illustrating an unfolded state of the hinge assembly according to an embodiment;
FIG. 5 is a front view illustrating an unfolded state of the hinge assembly according to an embodiment;
FIG. 6 is a rear view illustrating an unfolded state of the hinge assembly according to an embodiment;
FIG. 7A is a perspective view of a first arm member according to an embodiment;
FIG. 7B is a front view of the first arm member according to an embodiment;
FIG. 7C is a bottom view of the first arm member according to an embodiment;
FIG. 8 is a perspective view of an arm member according to an embodiment;
FIG. 9 is a perspective view of an arm member according to an embodiment;
FIG. 10 is a front view illustrating a cam member according to an embodiment;
FIG. 11 is a perspective view illustrating a first arm bracket according to an embodiment;
FIG. 12 is a perspective view of a first wing member according to an embodiment;
FIG. 13 is a perspective view illustrating a first wing bracket according to an embodiment;
FIG. 14A is a partial cross-sectional view taken along the line I-I in FIG. 5 with an electronic device in an unfolded state, based on a state in which a hinge assembly is applied to the electronic device, according to an embodiment;
FIG. 14B is a partial cross-sectional view taken along the line I-I in FIG. 5 with the electronic device in a folded state, based on a state in which the hinge assembly is applied to the electronic device, according to an embodiment;
FIG. 15A is a partial cross-sectional view taken along the line II-II in FIG. 5 with an electronic device in an unfolded state, based on a state in which a hinge assembly is applied to the electronic device, according to an embodiment;
FIG. 15B is a partial cross-sectional view taken along the line II-II in FIG. 5 with the electronic device in a folded state, based on a state in which the hinge assembly is applied to the electronic device, according to an embodiment;
FIG. 16A is a partial cross-sectional view taken along the line III-III in FIG. 5 with an electronic device in an unfolded state, based on a state in which a hinge assembly is applied to the electronic device, according to an embodiment;
FIG. 16B is a partial cross-sectional view taken along the line III-III in FIG. 5 with the electronic device in a folded state, based on a state in which the hinge assembly is applied to the electronic device, according to an embodiment;
FIG. 17A is a partial cross-sectional view taken along the line IV-IV in FIG. 5 with an electronic device in an unfolded state, based on a state in which a hinge assembly is applied to the electronic device, according to an embodiment;
FIG. 17B is a partial cross-sectional view taken along the line IV-IV in FIG. 5 with the electronic device in a folded state, based on a state in which the hinge assembly is applied to the electronic device, according to an embodiment;
FIG. 18 is a front view illustrating an arm member according to an embodiment;
FIG. 19A is a front view illustrating a hinge assembly according to an embodiment;
FIG. 19B is a partial side view illustrating the hinge assembly according to an embodiment;
FIG. 20 is a front view illustrating a hinge assembly according to an embodiment;
FIG. 21 is an enlarged view illustrating a cam portion of an arm member and a cam portion of a cam member, according to an embodiment;
FIG. 22A is a partial front view illustrating a hinge assembly according to an embodiment;
FIG. 22B is a perspective view of an arm member according to an embodiment;
FIG. 22C is a plan view of the arm member according to an embodiment;
FIG. 23A is a partial front view illustrating a hinge assembly according to an embodiment;
FIG. 23B is a perspective view of an arm member according to an embodiment; and
FIG. 23C is a plan view of the arm member according to an embodiment.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

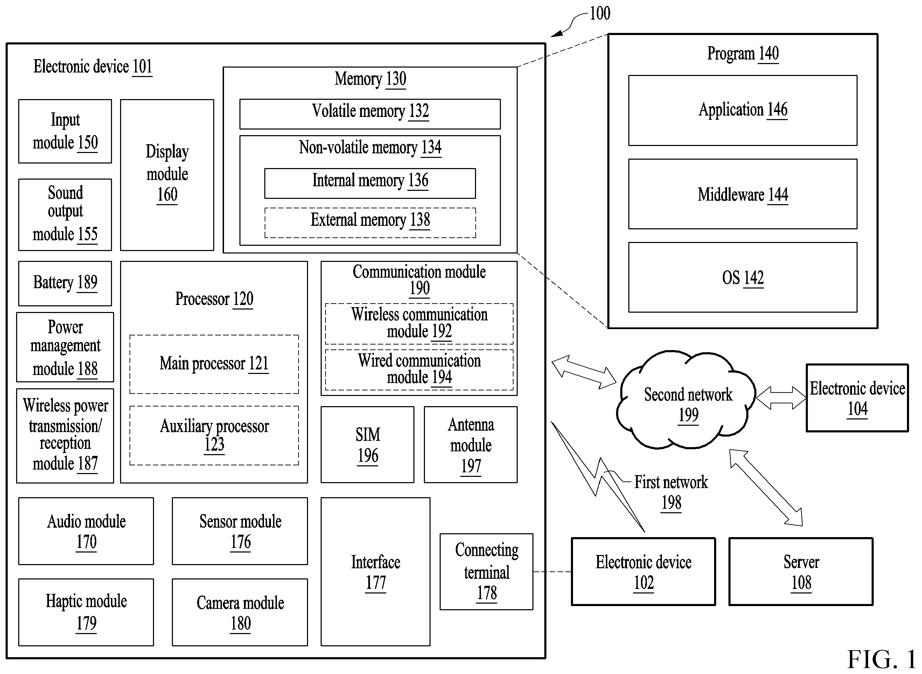

FIG. 1 is a block diagram illustrating an electronic device 101 in a network environment 100 according to an embodiment.

Referring to FIG. 1, the electronic device 101 in the network environment 100 may communicate with an electronic device 102 via a first network 198 (e.g., a short-range wireless communication network) or communicate with an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the above components may be omitted from the electronic device 101, or one or more other components may be added to the electronic device 101. In an embodiment, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently from or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a portion of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for processing of an artificial intelligence (AI) model. An AI model may be generated by machine learning. Such learning may be performed by, for example, the electronic device 101 in which AI is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store a variety of data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and a control circuit to control a corresponding one of the display, the hologram device, and the projector. According to an embodiment, the display module 160 may include a touch sensor adapted to sense a touch or a pressure sensor adapted to measure an intensity of a force incurred by the touch.

The audio module 170 may convert a sound into an electric signal and vice versa. According to an embodiment, the audio module 170 may obtain the sound via the input module 150 or output the sound via the sound output module 155 or an external electronic device (e.g., an electronic device 102 such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and may generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

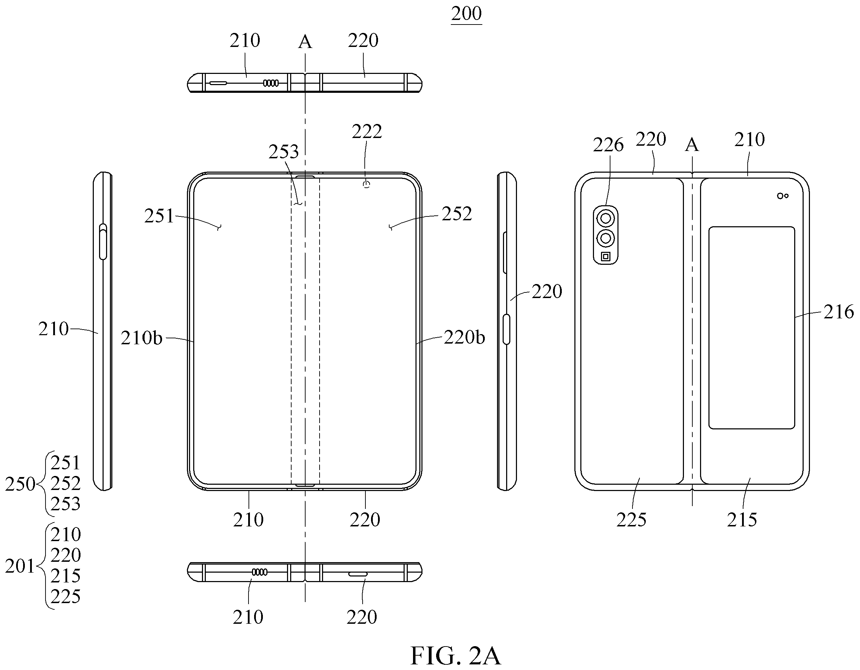

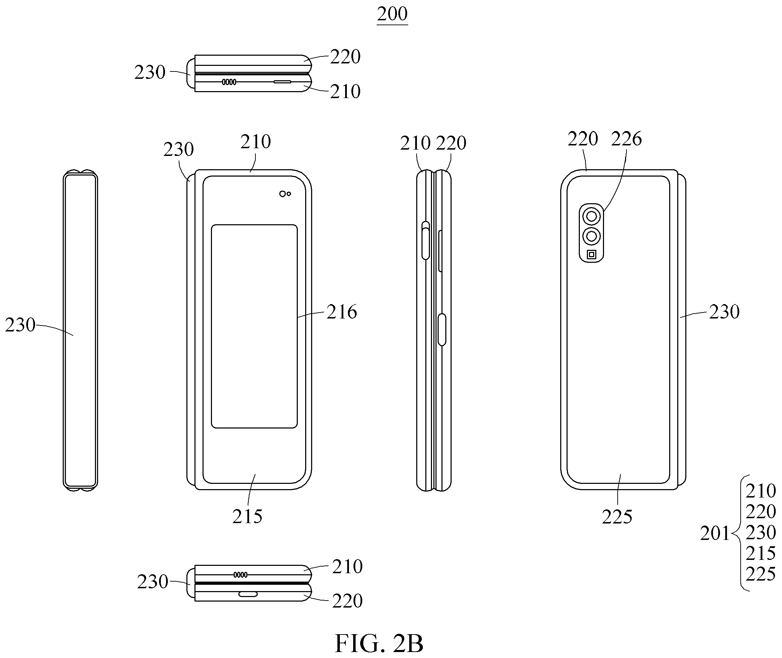

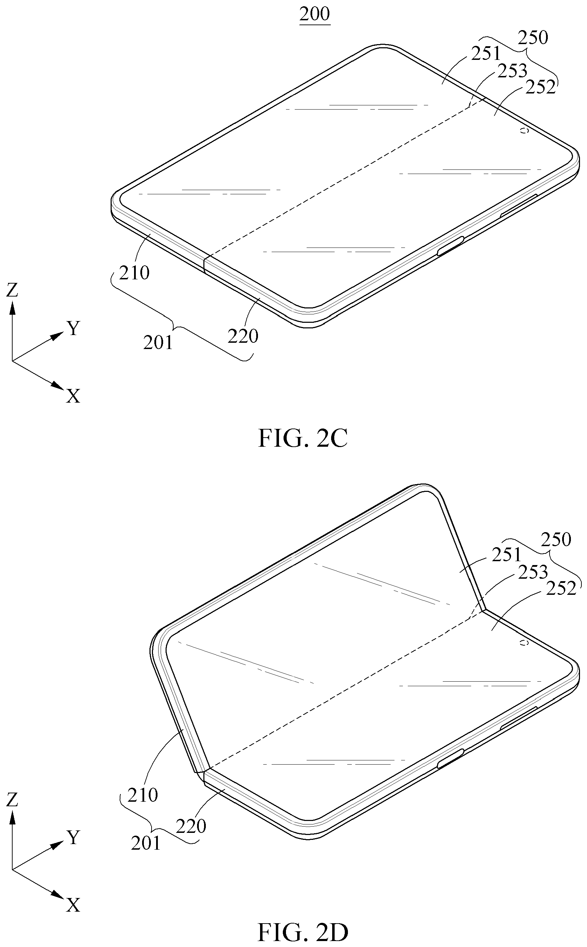

FIG. 2A is a diagram illustrating an unfolded state of an electronic device 200 according to an embodiment. FIG. 2B is a diagram illustrating a folded state of the electronic device 200 according to an embodiment. FIG. 2C is a perspective view illustrating a fully unfolded state of the electronic device 200 according to an embodiment. FIG. 2D is a perspective view illustrating an example of a partially unfolded intermediate state of the electronic device 200 according to an embodiment.

The electronic device 200 of FIGS. 2A to 2D is an example of the electronic device 101 of FIG. 1 and may be a foldable or bendable electronic device.

In FIG. 2C and the other following drawings, illustrated is a spatial coordinate system defined by an X-axis, a Y-axis, and a Z-axis that are orthogonal to each other. Here, the X-axis may represent a width direction of an electronic device, the Y-axis may represent a length direction of the electronic device, and the Z-axis may represent a height (or thickness) direction of the electronic device. In the following description, a "first direction" may refer to a direction parallel to the Z-axis.

Referring to FIGS. 2A and 2B, in an embodiment, the electronic device 200 may include a foldable housing 201 and a flexible or foldable display 250 (hereinafter, the "display" 250 in short) (e.g., the display module 160 of FIG. 1) disposed in a space formed by the foldable housing 201. A surface on which the display 250 is disposed (or a surface on which the display 250 is viewed from an outside of the electronic device 200) may be defined as a front surface of the electronic device 200. In addition, a surface opposite to the front surface may be defined as a rear surface of the electronic device 200. In addition, a surface surrounding a space between the front surface and the rear surface may be defined as a side surface of the electronic device 200.

According to an embodiment, the foldable housing 201 may include a first housing structure 210, a second housing structure 220, a first rear cover 215, a second rear cover 225, and/or a hinge structure 230. For example, the hinge structure 230 may include a hinge cover that covers a foldable portion of the foldable housing 201. The foldable housing 201 of the electronic device 200 is not limited to the shape and combination shown in FIGS. 2A and 2B and may be implemented in a different shape or a different combination of components. For example, in an embodiment, the first housing structure 210 and the first rear cover 215 may be formed as one and the second housing structure 220 and the second rear cover 225 may be formed as one.

According to an embodiment, the first housing structure 210 may be connected to the hinge structure 230 and may include a first surface facing a first direction and a second surface facing a second direction opposite to the first direction. The second housing structure 220 may be connected to the hinge structure 230 and may include a third surface facing a third direction and a fourth surface facing a fourth direction opposite to the third direction. The second housing structure 220 may rotate with respect to the first housing structure 210 about the hinge structure 230. A state of the electronic device 200 may be changed to a folded state or an unfolded state.

According to an embodiment, the first surface may face the third surface in a state in which the electronic device 200 is fully folded, and the third direction may be substantially identical to the first direction in a state in which the electronic device 200 is fully unfolded.

According to an embodiment, the first housing structure 210 and the second housing structure 220 may be disposed on both sides of a folding axis A and may generally be symmetrical with respect to the folding axis A. As described below, an angle or distance between the first housing structure 210 and the second housing structure 220 may vary depending on whether the electronic device 200 is in the unfolded state, the folded state, or an intermediate state (e.g., a partially folded state or a partially unfolded state). According to an embodiment, the second housing structure 220 may include a sensor area 222 in which various sensors are disposed. For example, the various sensors may be positioned on the rear surface of the display 250 in the sensor area 222. According to an embodiment, the first housing structure 210 may include a sensor area (not shown) in which at least one sensor is disposed.

According to an embodiment, as illustrated in FIG. 2A, the first housing structure 210 and the second housing structure 220 may form a recess accommodating the display 250. According to an embodiment, a first portion 220a of the second housing structure 220 may differ from a second portion 220b of the second housing structure 220 in terms of distance from the folding axis A. The width of the recess is not limited to the shown example. In an embodiment, the recess may have a plurality of widths due to asymmetrical portions of the first housing structure 210 and the second housing structure 220. In an embodiment, components embedded in the electronic device 200 to perform various functions may be exposed from the front surface of the electronic device 200 through the sensor area 222 or through one or more openings provided in the sensor area 222. In an embodiment, the components may include various types of sensors. The sensors may include, for example, at least one of a front camera, a receiver, or a proximity sensor. According to an embodiment, the sensor area 222 may not be included in the second housing structure 220 or may be formed at a position different from that shown in the drawings.

According to an embodiment, at least a portion of the first housing structure 210 and the second housing structure 220 may include a metal material or a non-metal material having a selected magnitude of rigidity to support the display 250. For example, at least a portion of the first housing structure 210 and the second housing structure 220 formed of the metal material may provide a ground plane for the electronic device 200 and may be electrically connected to a ground line formed on a PCB disposed in the foldable housing 201.

According to an embodiment, the first rear cover 215 may be disposed on one side of the folding axis A on the rear surface of the electronic device 200. For example, the first rear cover 215 may have a substantially rectangular periphery that may be surrounded by the first housing structure 210. For example, the second rear cover 225 may be disposed on another side of the folding axis A on the rear surface of the electronic device 200. For example, the periphery of the second rear cover 225 may be surrounded by the second housing structure 220.

According to an embodiment, the first rear cover 215 may be substantially symmetrical to the second rear cover 225 with respect to the folding axis A. However, the first rear cover 215 and the second rear cover 225 are not necessarily mutually symmetrical, and in another embodiment, the electronic device 200 may include a first rear cover 215 and a second rear cover 225 having various shapes. In an embodiment, the first rear cover 215 may be formed integrally with the first housing structure 210 and the second rear cover 225 may be formed integrally with the second housing structure 220.

According to an embodiment, the first rear cover 215, the second rear cover 225, the first housing structure 210, and the second housing structure 220 may form a space in which various components (e.g., a PCB or a battery) of the electronic device 200 are to be arranged. In an embodiment, one or more components may be disposed or visually exposed on the rear surface of the electronic device 200. For example, at least a portion of a sub-display may be visually exposed through a first rear area 216 of the first rear cover 215. In an embodiment, one or more components or sensors may be visually exposed through a second rear area 226 of the second rear cover 225. In an embodiment, the sensors may include a proximity sensor and/or a rear camera.

According to an embodiment, a front camera exposed from the front surface of the electronic device 200 through one or more openings provided in the sensor area 222, or a rear camera exposed through the second rear area 226 of the second rear cover 225 may include one or more lenses, an image sensor, and/or an ISP. A flash may include, for example, a light-emitting diode (LED) or a Xenon lamp. In an embodiment, two or more lenses (e.g., infrared camera, wide-angle, and telephoto lenses) and image sensors may be arranged on one surface of the electronic device 200.

Referring to FIG. 2B, the hinge cover may be disposed between the first housing structure 210 and the second housing structure 220 to cover internal components (e.g., the hinge structure 230). According to an embodiment, the hinge structure 230 may be covered by a portion of the first housing structure 210 and a portion of the second housing structure 220, or may be exposed to the outside, depending on the state (e.g., the unfolded state, the intermediate state, or the folded state) of the electronic device 200.

In an embodiment, when the electronic device 200 is in the unfolded state (e.g., a fully unfolded state) as illustrated in FIG. 2A, the hinge structure 230 may be covered by the first housing structure 210 and the second housing structure 220 not to be exposed. In another example, when the electronic device 200 is in the folded state (e.g., a fully folded state), as shown in FIG. 2B, the hinge structure 230 may be exposed to the outside between the first housing structure 210 and the second housing structure 220. In another example, when the first housing structure 210 and the second housing structure 220 are in an intermediate state of being folded with a predetermined angle, at least a portion of the hinge cover 230 may be exposed to the outside between the first housing structure 210 and the second housing structure 220. In this example, an exposed area may be less than an area exposed in the fully folded state. In an embodiment, the hinge cover 230 may have a curved surface.

According to an embodiment, the display 250 may be disposed in a space formed by the foldable housing 201. For example, the display 250 may be seated on the recess formed by the foldable housing 201 and may be viewed from the outside through the front surface of the electronic device 200. For example, the display 250 may form most of the front surface of the electronic device 200. Accordingly, the front surface of the electronic device 200 may include the display 250, and a partial area of the first housing structure 210 and a partial area of the second housing structure 220, which are adjacent to the display 250. In addition, the rear surface of the electronic device 200 may include the first rear cover 215, a partial area of the first housing structure 210 adjacent to the first rear cover 215, the second rear cover 225, and a partial area of the second housing structure 220 adjacent to the second rear cover 225.

According to an embodiment, the display 250 may refer to a display having at least a partial area that is transformable into a flat surface or a curved surface. In an embodiment, the display 250 may include a folding area 253, a first area 251 disposed on one side of the folding area 253 (e.g., on the left side of the folding area 253 shown in FIG. 2A), and a second area 252 disposed on the other side of the folding area 253 (e.g., on the right side of the folding area 253 shown in FIG. 2A).

However, such an area division of the display 250 shown in FIG. 2A is only an example. The display 250 may be divided into a plurality of areas (e.g., four or more areas or two areas) depending on a structure or functions of the display 250. For example, as shown in FIG. 2A, the display 250 may be divided into areas based on the folding area 253 extending in parallel to the folding axis A. In an embodiment, the display 250 may be divided into areas based on another folding axis (e.g., a folding axis parallel to a width direction of an electronic device).

According to an embodiment, the display 250 may be coupled to or disposed adjacent to a touch panel including a touch sensing circuit and a pressure sensor for measuring a strength (pressure) of a touch. For example, the display 250 may be coupled to or disposed adjacent to a touch panel for detecting a stylus pen of an electromagnetic resonance (EMR) type, as an example of the touch panel.

According to an embodiment, the first area 251 and the second area 252 may have globally symmetrical shapes around the folding area 253. However, unlike the first area 251, the second area 252 may include a notch that is cut depending on the presence of the sensor area 222 but may have a shape symmetrical to the first area 251 in the other areas. For example, the first area 251 and the second area 252 may include portions having mutually symmetrical shapes and portions having mutually asymmetrical shapes.

According to an embodiment, an edge thickness of each of the first area 251 and the second area 252 may be different from an edge thickness of the folding area 253. The edge thickness of the folding area 253 may be less than those of the first area 251 and the second area 252. For example, the first area 251 and the second area 252 may be asymmetrical in terms of thickness when cross-sectionally viewed. For example, an edge of the first area 251 may be formed to have a first radius of curvature, and an edge of the second area 252 may be formed to have a second radius of curvature, wherein the second radius of curvature is different from the first radius of curvature. In an embodiment, the first area 251 and the second area 252 may be symmetrical in terms of thickness when cross-sectionally viewed.

Hereinafter, each area of the display 250 and operations of the first housing structure 210 and the second housing structure 220 depending on the state (e.g., the folded state, the unfolded state, or the intermediate state) of the electronic device 200 are described.

According to an embodiment, when the electronic device 200 is in the unfolded state (e.g., FIG. 2A), the first housing structure 210 and the second housing structure 220 may be arranged to face the same direction while forming an angle of about 180 degrees. The surface of the first area 251 and the surface of the second area 252 of the display 250 may face the same direction (e.g., a front direction of an electronic device) while forming 180 degrees. The folding area 253 may form the same plane in conjunction with the first area 251 and the second area 252.

According to an embodiment, when the electronic device 200 is in the folded state (e.g., FIG. 2B), the first housing structure 210 and the second housing structure 220 may be arranged to face each other. The surface of the first area 251 and the surface of the second area 252 of the display 250 may face each other, forming a narrow angle (e.g., between 0 degrees to 10 degrees). At least a portion of the folding area 253 may form a curved surface having a predetermined curvature.

According to an embodiment, when the electronic device 200 is in the intermediate state, the first housing structure 210 and the second housing structure 220 may be arranged to form a predetermined angle therebetween. The surface of the first area 251 and the surface of the second area 252 of the display 250 may form an angle greater than that in the folded state and less than that in the unfolded state. At least a portion of the folding area 253 may include a curved surface having a predetermined curvature, and the curvature may be less than that in the folded state.

FIG. 2C illustrates a fully unfolded state of the electronic device 200. FIG. 2D illustrates an intermediate state in which the electronic device 200 is partially unfolded. As described above, the state of the electronic device 200 may be changed to the folded state or the unfolded state. According to an embodiment, when viewed in a direction of a folding axis (e.g., the folding axis A of FIG. 2A), the electronic device 200 may be folded in two types, i.e., an "in-folding" type in which the front surface of the electronic device 200 is folded to form an acute angle and an "out-folding" type in which the front surface of the electronic device 200 is folded to form an obtuse angle. For example, in the state in which the electronic device 200 is folded in the in-folding type, the first surface of the first housing structure 210 may face the third surface of the second housing structure 220. In the fully unfolded state, the first surface of the first housing structure 210 and the third surface of the second housing structure 220 may face the same direction (e.g., a direction parallel to the z-axis).

In another example, when the electronic device 200 is folded in the out-folding type, the second surface of the first housing structure 210 may face the fourth surface of the second housing structure 220.

In addition, although not shown in the drawings, the electronic device 200 may include a plurality of hinge axes (e.g., two parallel hinge axes including the axis A of FIG. 2A and another axis parallel to the axis A). In this case, the electronic device 200 may be folded in a "multi-folding" manner in which the in-folding and out-folding types are combined.

The in-folding type may refer to a state in which the display 250 is not exposed to the outside in the fully folded state. The out-folding type may refer to a state in which the display 250 is exposed to the outside in the fully folded state. FIG. 2D illustrates the intermediate state in which the electronic device 200 is partially unfolded in an in-folding process.

Although the state in which the electronic device 200 is folded in the in-folding type is described below for convenience's sake, it should be noted that the description may be similarly applied to the state in which the electronic device 200 is folded in the out-folding type.

The electronic device according to one embodiment may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that embodiments of the disclosure and the terms used therein are not intended to limit the technological features set forth herein to particular embodiments. In connection with the description of the drawings, like reference numerals may be used for similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," may include any one of the items listed together in the corresponding one of the phrases, or all possible combinations thereof. Terms such as "1st" and "2nd," or "first" and "second" may be used to simply distinguish a corresponding component from other components, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments of the present disclosure as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

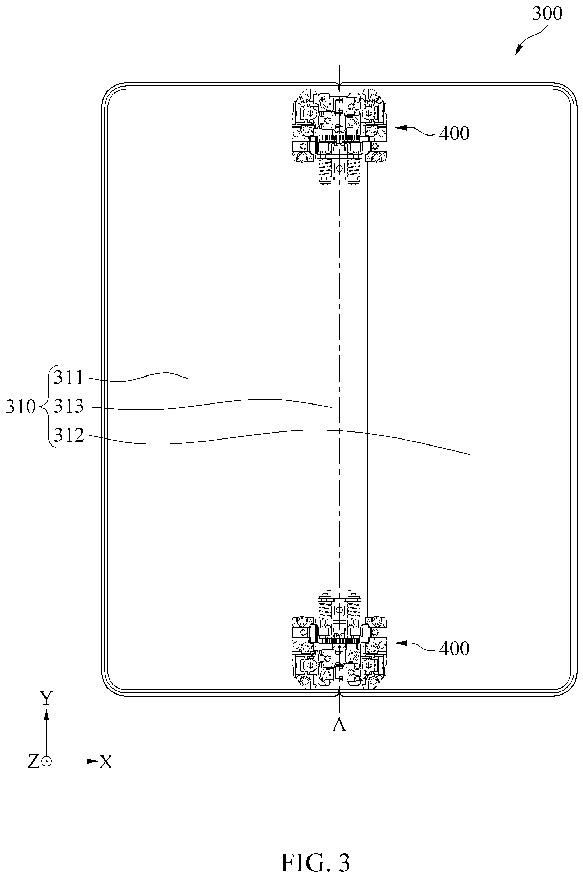

FIG. 3 is a front view illustrating a state in which a hinge assembly is applied to an electronic device according to an embodiment.

Referring to FIG. 3, an electronic device 300 (e.g., the electronic device 101 of FIG. 1 or the electronic device 200 of FIGS. 2A to 2D) according to an embodiment may be a foldable electronic device. For example, the electronic device 300 may be folded or unfolded around a folding axis A. However, FIG. 3 is just an example, and the size, shape, structure, and hinge axis of the electronic device 300 are not limited thereto. For example, although the electronic device 300 of FIG. 3 may include the folding axis A in a Y direction (e.g., a long side direction), an electronic device according to an embodiment may include a folding axis in an X direction (e.g., a short side direction).

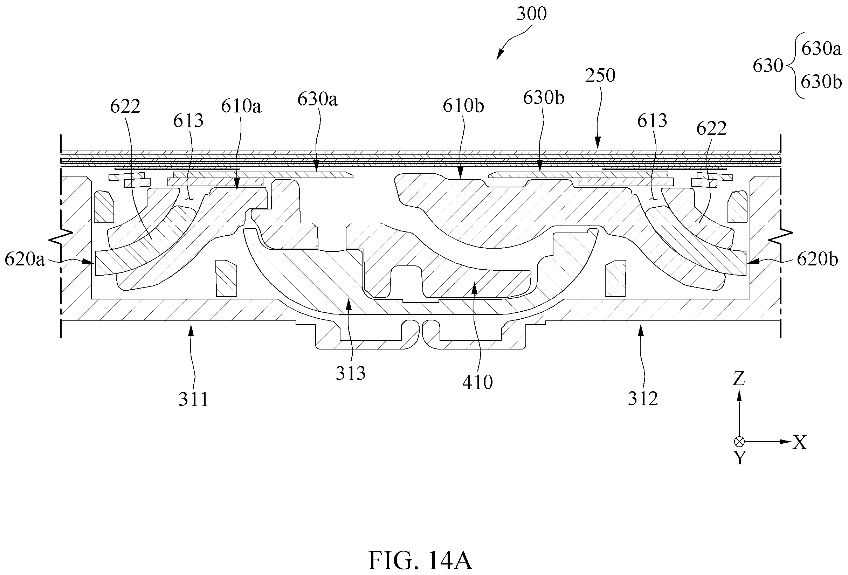

The electronic device 300 according to an embodiment may include a housing 310 (e.g., the foldable housing 201 of FIGS. 2A to 2D), a display (not shown) (e.g., the display module 160 of FIG. 1 or the display 250 of FIGS. 2A to 2D), a hinge assembly 400, and/or a wing plate 630 (e.g., the wing plate 630 of FIG. 14A).

In an embodiment, the housing 310 may form at least a portion of the exterior of the electronic device 300. The housing 310 may include a first housing 311 (e.g., the first housing structure 210 of FIGS. 2A to 2D), a second housing 312 (e.g., the second housing structure 220 of FIGS. 2A to 2D), and a hinge housing 313.

In an embodiment, the first housing 311 and the second housing 312 may be foldably connected to each other by the hinge assembly 400. An angle or distance between the first housing 311 and the second housing 312 may vary depending on whether the electronic device 300 is in a flat state or unfolded state, a folded state, or an intermediate state. The intermediate state described above may include all states between the unfolded state and the folded state. The hinge housing 313 may be between the first housing 311 and the second housing 312 to provide a space in which an internal component (e.g., the hinge assembly 400) is disposed. For example, the hinge housing 313 may be configured to cover the hinge assembly 400 such that the hinge assembly 400 may not be exposed to the outside.

In an embodiment, the first housing 311 and the second housing 312 may provide a space in which the display 250 is disposed. For example, the display 250 may be a foldable flexible display. For example, the display 250 may include a first area (e.g., the first area 251 of FIG. 2C), a second area (e.g., the second area 252 of FIG. 2C), and a folding area (e.g., the folding area 253 of FIG. 2C) between the first area and the second area. The first housing 311 may be disposed at a position corresponding to the first area 251 of the display 250 to support the first area 251 of the display 250. The second housing 312 may be disposed at a position corresponding to the second area 252 of the display 250 to support the second area 252 of the display 250.

In an embodiment, the hinge assembly 400 may be disposed between the first housing 311 and the second housing 312 to connect the first housing 311 to the second housing 312. For example, the hinge structure 230 of FIG. 2B may include a plurality of hinge assemblies 400. The plurality of hinge assemblies 400 may be spaced apart along the folding axis A (e.g., Y direction). For example, as illustrated in FIG. 3, two hinge assemblies 400 may be spaced apart along the folding axis A. However, this is only an example, and the number of hinge assemblies 400 is not limited thereto. The hinge assembly 400 may implement a folding or unfolding operation of the electronic device 300. The hinge assembly 400 may operate between a folded state and an unfolded state, in which the first area 251 and the second area 252 face each other in the folded state and the first area 251 and the second area 252 do not face each other in the unfolded state. The hinge assembly 400 may generate a force to maintain a predetermined folded state of the electronic device 300. For example, when the electronic device 300 is in the folded state, the hinge assembly 400 may generate a force (e.g., a close detent force) to maintain the folded state of the electronic device 300. When the electronic device 300 is in the unfolded state, the hinge assembly 400 may generate a force (e.g., an open detent force) to maintain the unfolded state of the electronic device 300. When the electronic device 300 is in the intermediate state, the hinge assembly 400 may generate a force (e.g., a free-stop force) to maintain the intermediate state of the electronic device 300.

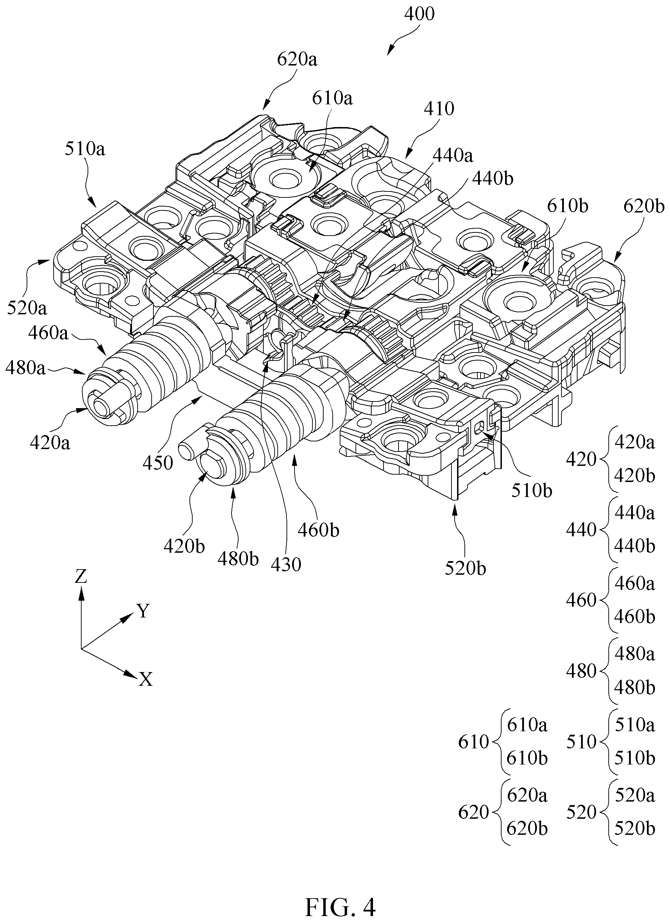

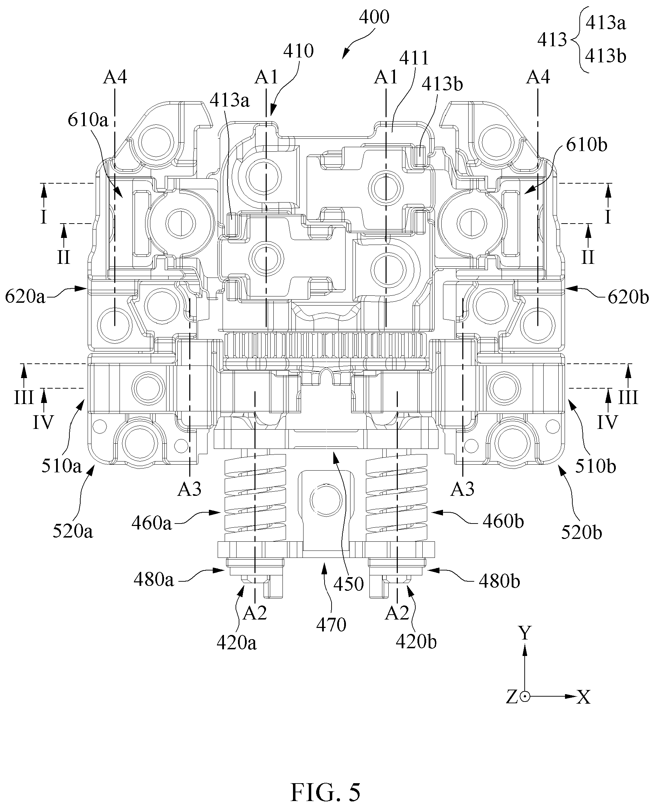

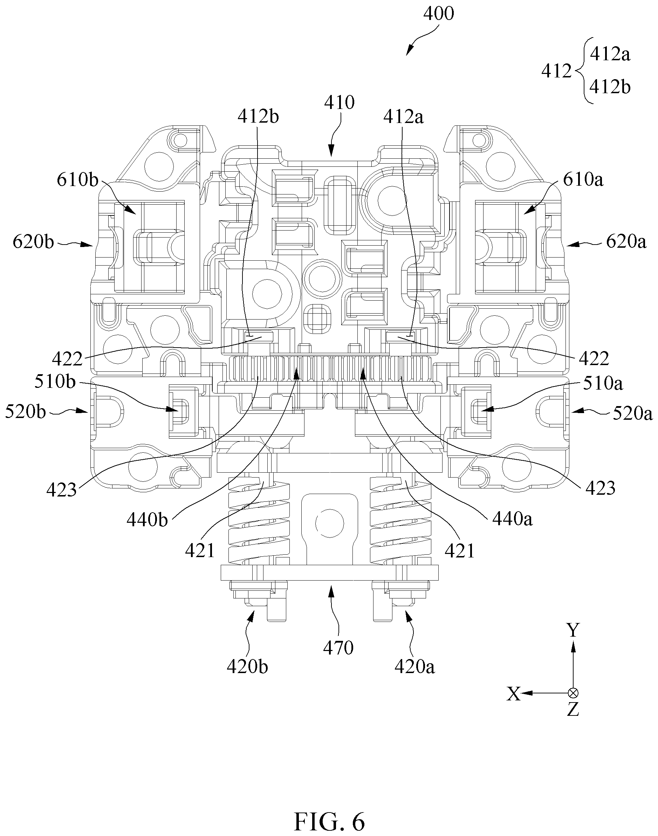

FIG. 4 is a perspective view illustrating an unfolded state of a hinge assembly according to an embodiment. FIG. 5 is a front view illustrating an unfolded state of the hinge assembly according to an embodiment. FIG. 6 is a rear view illustrating an unfolded state of the hinge assembly according to an embodiment.

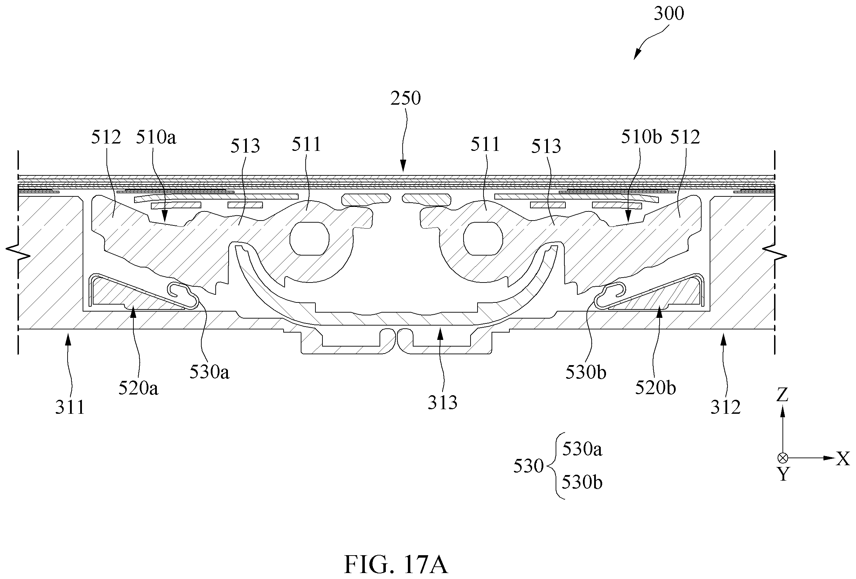

Referring to FIGS. 4 to 6, the hinge assembly 400 according to an embodiment may include a hinge bracket 410, a shaft 420, a gear bracket 430, an idle gear 440, a cam member 450, a pressing member 460, a shaft bracket 470, a fastening member 480, an arm member 510, an arm bracket 520, an elastic member (e.g., elastic members 530a and 530b of FIG. 17A), a wing member 610, and/or a wing bracket 620.

In an embodiment, the hinge assembly 400 comprises a hinge bracket 410, a shaft 420, an arm member 510, a cam member 450, a pressing member 460 and an arm bracket 520, whereas in another embodiment, the hinge assembly 400 comprises a wing member 610 and an arm member 510. These two embodiments can be combined or independent of each other. In addition, the structure of the hinge assembly 400 is not limited to the above embodiments. Where appropriate, some of the members in the above-exemplified hinge assembly 400 may be modified or omitted, whereas other compatible components can be added, or replace some of the members in the above hinge assembly 400, where appropriate.

In an embodiment, the hinge bracket 410 may be fixedly connected to a housing (e.g., the housing 310 of FIG. 3). For example, the hinge bracket 410 may be fixedly connected to a hinge housing (e.g., the hinge housing 313 of FIG. 3).

In an embodiment, the hinge bracket 410 may include a hinge bracket body 411, a shaft coupling portion 412, and a protruding guide rail 413.

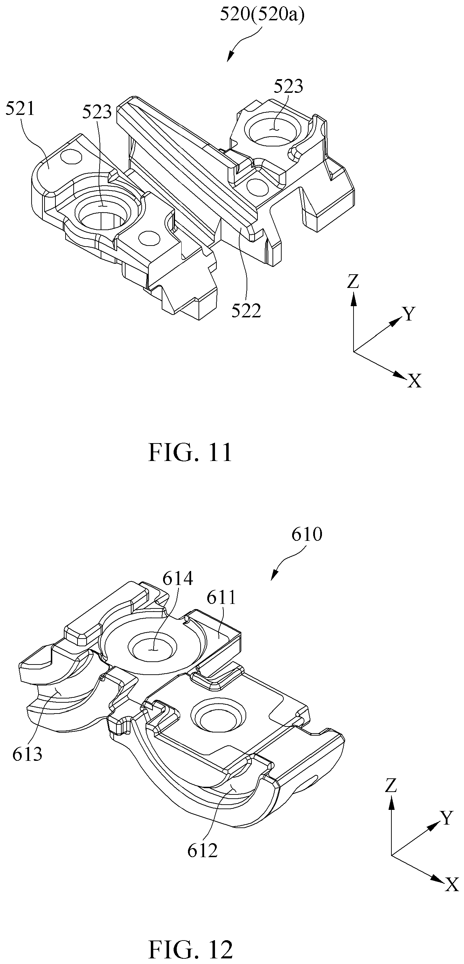

In an embodiment, the hinge bracket body 411 may form the exterior of the hinge bracket 410. The shaft coupling portion 412 may be formed in the hinge bracket body 411. For example, the shaft coupling portion 412 may be formed at one end (e.g., an end in a -Y direction) of the hinge bracket body 411. The shaft coupling portion 412 may provide a space to which a protruding end 422 of the shaft 420 is coupled. A pair of shaft coupling portions 412 may be formed. For example, the shaft coupling portion 412 may include a first shaft coupling portion 412a and a second shaft coupling portion 412b. The first shaft coupling portion 412a and the second shaft coupling portion 412b may be spaced apart from each other in a width direction (e.g., X direction). The protruding guide rail 413 may be formed in the hinge bracket body 411. The protruding guide rail 413 may be a component that helps the wing member 610 to be rotatably connected to the hinge bracket 410. The protruding guide rail 413 may interoperate with a recessed guide rail (e.g., a recessed guide rail 612 of FIG. 12) of the wing member 610 to be described below. For example, the protruding guide rail 413 may include an arc shape having a first axis A1 as the center. For example, the protruding guide rail 413 may be formed by protruding in a rail shape within a space in which the hinge bracket body 411 is recessed to allow insertion of the wing member 610. A pair of protruding guide rails 413 may be formed. For example, the protruding guide rail 413 may include a first protruding guide rail 413a and a second protruding guide rail 413b. For example, the first protruding guide rail 413a may be formed on one side (e.g., a side in a -X direction) of the hinge bracket body 411 and the second protruding guide rail 413b may be formed on the other side (e.g., a side in a +X direction) of the hinge bracket body 411. However, the positions, sizes, and shapes of the hinge bracket body 411, the shaft coupling portion 412, and/or the protruding guide rail 413 illustrated in the drawings are just examples and not limited thereto.

In an embodiment, the shaft 420 may be rotatably connected to the hinge bracket 410. The shaft 420 may be formed to have a longitudinal direction (e.g., Y direction). The longitudinal axis of the shaft 420 may function as the second axis A2, which is a rotation axis of the arm member 510 connected to the shaft 420. The second axis A2 may be different from the first axis A1, which is a rotation axis of the wing member 610 with respect to the hinge bracket 410. The shaft 420 may include a shaft body 421, the protruding end 422, and a gear portion 423. The shaft body 421 may be a portion formed in a longitudinal direction (e.g., Y direction). The protruding end 422 may be formed by protruding from one end (e.g., an end in a +Y direction) of the shaft body 421 in a radial direction to have a greater diameter than the shaft body 421. As the protruding end 422 is rotatably inserted into the shaft coupling portion 412 formed in the hinge bracket 410, the shaft 420 may be rotatably connected to the hinge bracket 410. The gear portion 423 may formed by protruding from the shaft body 421 to have a gear structure. For example, the gear portion 423 may be integrally formed with the shaft body 421. For example, the gear portion 423 may be adjacent to the protruding end 422. A pair of shafts 420 may be provided. For example, the shaft 420 may include a first shaft 420a and a second shaft 420b. The first shaft 420a and the second shaft 420b may be inserted into the first shaft coupling portion 412a and the second shaft coupling portion 412b, respectively.

In an embodiment, the idle gear 440 may be positioned between the gear portion 423 of the first shaft 420a and the gear portion 423 of the second shaft 420b. For example, a pair of idle gears 440 may be provided. The idle gear 440 may include a first idle gear 440a and a second idle gear 440b. The first idle gear 440a and the second idle gear 440b may be adjacent to each other and gear interoperation between the first idle gear 440a and the second idle gear 440b may be implemented. The first idle gear 440a may interoperate with the gear portion 423 of the first shaft 420a and the second idle gear 440b may interoperate with the gear portion 423 of the second shaft 420b. The first idle gear 440a and the second idle gear 440b may implement interoperation between the motion of the first housing 311 and the motion of the second housing 312. For example, the first idle gear 440a and the second idle gear 440b may synchronize the rotation of the first shaft 420a with the rotation of the second shaft 420b. When the shaft 420 is rotatably connected to the hinge bracket 410, the gear bracket 430 may be inserted into the shaft 420 to pass through the shaft 420. The gear bracket 430 may fix the position of the idle gear 440. The idle gear 440 may be rotatably connected to each of the gear bracket 430 and the hinge bracket 410. The structure that implements interoperation between the motion of the first housing 311 and the motion of the second housing 312 is not limited thereto. For example, in an embodiment, the hinge assembly 400, on behalf of the gear portion 423, may implement interoperation between the motion of the first housing 311 and the motion of the second housing 312 through a spiral interoperation structure. For example, in the spiral interoperation structure, a spiral protruding rail or a spiral recessed rail formed in a first arm member 510a may move by engaging with a spiral recessed rail or a spiral protruding rail formed in a second arm member 510b. For example, the first arm member 510a may be connected to the first housing 311 through a first arm bracket 520a and the second arm member 510b, which interoperates with the first arm member 510a through a recessed or protruding rail, may be connected to the second housing 312 through a second arm bracket 520b, and thus, interoperation between the motion of the first housing 311 and the motion of the second housing 312 may be implemented.

In an embodiment, the arm member 510 may be connected to the shaft 420 to integrally rotate with the shaft 420 with respect to the hinge bracket 410. The arm member 510 may rotate around the second axis A2, which is the longitudinal direction of the shaft 420, with respect to the hinge bracket 410. For example, the shaft 420 may be pressed in and connected to the arm member 510. A pair of arm members 510 may be provided. For example, the arm member 510 may include the first arm member 510a and the second arm member 510b. The first arm member 510a and the second arm member 510b may be connected to the first shaft 420a and the second shaft 420b, respectively. In an embodiment, the arm member 510 may be formed integrally with the shaft 420.

In an embodiment, the shaft 420 may be inserted into the cam member 450 such that cam interoperation between the arm member 510 and the cam member 450 is implemented. For example, the cam member 450 may face the arm member 510. As interoperation between the cam member 450 and the arm member 510 is implemented, the cam member 450 may implement a detent force and/or a free-stop force.

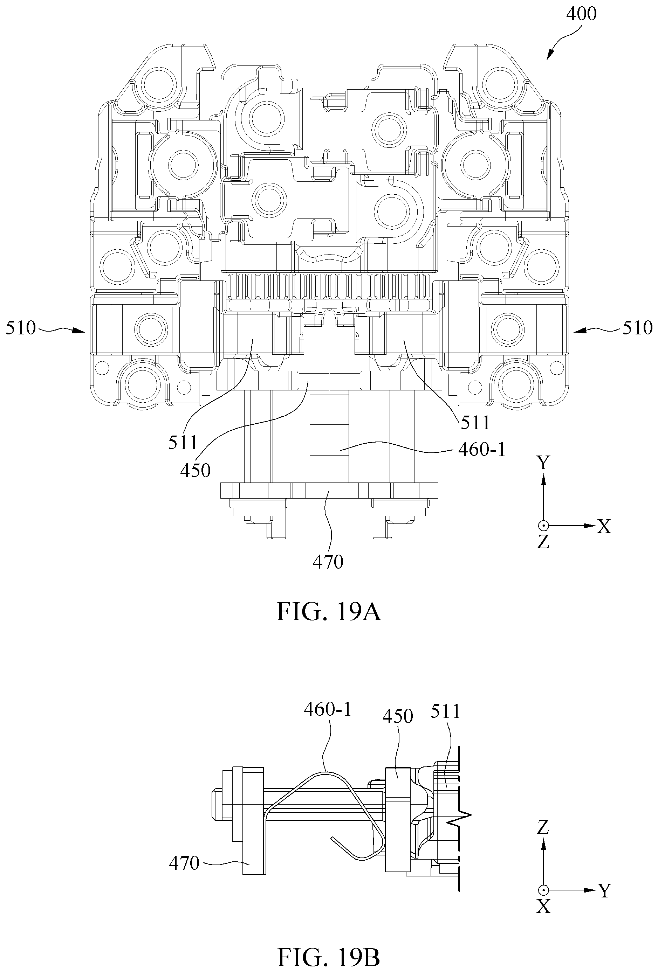

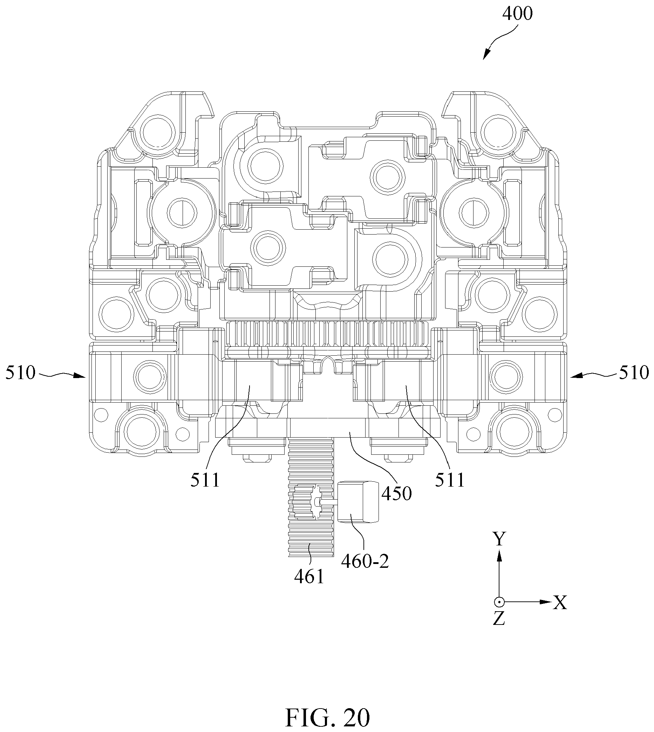

In an embodiment, the pressing member 460 may apply pressure to the cam member 450 toward the arm member 510. For example, the pressing member 460 may include a cylindrical spring. A pair of pressing members 460 may be provided. For example, the pressing member 460 may include a first pressing member 460a and a second pressing member 460b. The first shaft 420a and the second shaft 420b may be inserted into the first pressing member 460a and the second pressing member 460b, respectively. This description is just an example. The pressing member 460 may include at least one of a cylindrical spring, a plate spring (e.g., a plate spring 460-1 of FIG. 19B), or an actuator (e.g., an actuator 460-2 of FIG. 20). The pressing force of the pressing member 460 may implement the detent force and/or the free-stop force of the hinge assembly 400.

In an embodiment, in a state the shaft 420 is inserted into the pressing member 460, the shaft 420 may be inserted into the shaft bracket 470. For example, both the first shaft 420a and the second shaft 420b may be inserted into the shaft bracket 470. The shaft bracket 470 may maintain the distance between the first shaft 420a and the second shaft 420b. For example, the shaft bracket 470 may be fixedly connected to a hinge housing (e.g., the hinge housing 313 of FIG. 3).

In an embodiment, the fastening member 480 may be inserted into an end (e.g., an end in a -Y direction) of the shaft 420. The fastening member 480 may be fixedly positioned at the end (e.g., the end in the -Y direction) of the shaft 420. The fastening member 480 may prevent a component (e.g., the gear bracket 430, the arm member 510, the cam member 450, the pressing member 460, and/or the shaft bracket 470) inserted into the shaft 420 from being separated from the shaft 420. For example, the fastening member 480 may include an e-ring and/or a washer. A pair of fastening members 480 may be provided. For example, the fastening member 480 may include a first fastening member 480a and a second fastening member 480b. The first shaft 420a and the second shaft 420b may be inserted into the first fastening member 480a and the second fastening member 480b, respectively.

In an embodiment, the arm bracket 520 may be slidably (e.g., rotatably) connected to the arm member 510. For example, the arm bracket 520 may be connected to the arm member 510 to rotate around a third axis A3. A pair of arm brackets 520 may be provided. For example, the arm bracket 520 may include the first arm bracket 520a and the second arm bracket 520b. In an embodiment, the first arm bracket 520a and the second arm bracket 520b may be slidably connected to the first arm member 510a and the second arm member 510b, respectively. The arm bracket 520 may be connected to a first housing (e.g., the first housing 311 of FIG. 3) or a second housing (e.g., the second housing 312 of FIG. 3). For example, the first arm bracket 520a and the second arm bracket 520b may be connected to the first housing 311 and the second housing 312, respectively.

In an embodiment, the wing member 610 may be rotatably connected to the hinge bracket 410. The wing member 610 may be rotatably connected to the hinge bracket 410 through the protruding guide rail 413 of the hinge bracket 410. The wing member 610 may rotate around the first axis A1, which is the center of the protruding guide rail 413, with respect to the hinge bracket 410. A pair of wing members 610 may be provided. For example, the wing member 610 may include a first wing member 610a and a second wing member 610b. The first wing member 610a and the second wing member 610b may be connected to the first protruding guide rail 413a and the second protruding guide rail 413b, respectively. A wing plate (e.g., the wing plate 630 of FIG. 14A) may be connected to the wing member 610. The wing plate 630 may support a display (e.g., the display 250 of FIG. 14A) to prevent the display 250 from sagging under the weight of the display 250. A pair of wing plates 630 may be provided. The wing plate 630 may include a first wing plate (e.g., a first wing plate 630a of FIG. 14A) and a second wing plate (e.g., a second wing plate 630b of FIG. 14A). The first wing plate 630a and the second wing plate 630b may support a first area (e.g., the first area 251 of FIG. 2C) and a second area (e.g., the second area 252 of FIG. 2C) of the display 250, respectively. The first wing plate 630a and the second wing plate 630b may be connected to the first wing member 610a and the second wing member 610b, respectively.

**In** an embodiment, the wing bracket 620 may be slidably (e.g., rotatably) connected to the wing member 610. For example, the wing bracket 620 may be connected to the wing member 610 to rotate around a fourth axis A4. The fourth axis A4 may be different from the third axis A3, which is a rotation axis of the arm bracket 520 with respect to the arm member 510. A pair of wing brackets 620 may be provided. For example, the wing bracket 620 may include a first wing bracket 620a and a second wing bracket 620b. The first wing bracket 620a and the second wing bracket 620b may be slidably connected to the first wing member 610a and the second wing member 610b, respectively. The wing bracket 620 may be connected to the first housing (e.g., the first housing 311 of FIG. 3) or the second housing (e.g., the second housing 312 of FIG. 3). For example, the first wing bracket 620a and the second wing bracket 620b may be connected to the first housing 311 and the second housing 312, respectively. The wing bracket 620 may be at least partially connected to the arm bracket 520. For example, the first wing bracket 620a and the second wing bracket 620b may be connected to the first arm bracket 520a and the second arm bracket 520b, respectively.

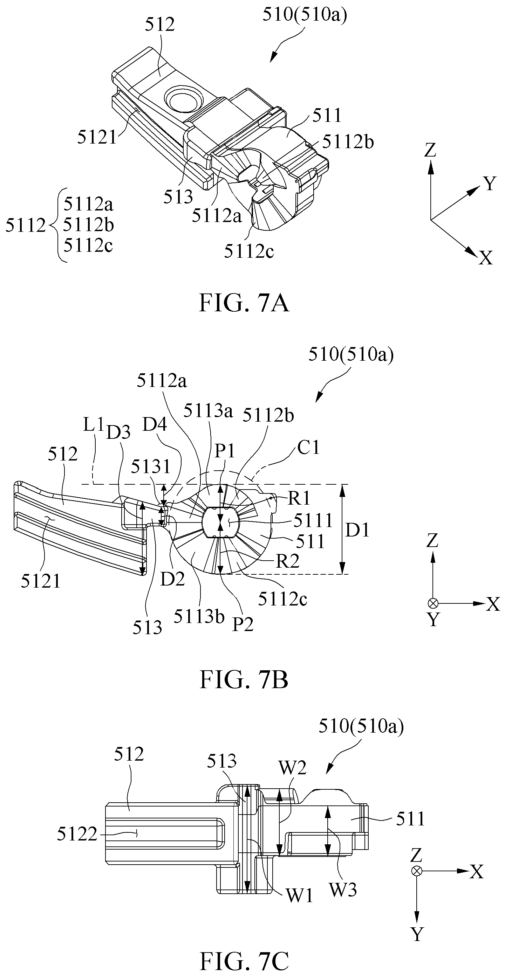

FIG. 7A is a perspective view of a first arm member according to an embodiment. FIG. 7B is a front view of the first arm member according to an embodiment. FIG. 7C is a bottom view of the first arm member according to an embodiment.

Hereinafter, the arm member 510 is described based on the first arm member 510a with reference to FIGS. 4 to 7C. The second arm member 510b may be substantially symmetrical to the first arm member 510a based on a folding axis (e.g., the folding axis A of FIG. 3).

In an embodiment, the arm member 510 may include a cam portion 511, a body portion 512, and a connecting portion 513.

In an embodiment, the cam portion 511 may be a portion in which a through hole 5111 and a cam crest 5112 are formed. The through hole 5111 may be a hole to which the shaft 420 is inserted. For example, a protrusion is formed on an inner circumferential surface of the through hole 5111 such that the shaft 420 may be pressed into the through hole 5111. The cam crest 5112 may be formed by protruding from a surface (e.g., a surface in a -Y direction) facing the direction of a second axis A2 of the cam portion 511 in a direction (e.g., -Y direction) facing the second axis A2. The cam crest 5112 may be formed to have a profile with a first inclined area, a flat area, and a second inclined area. However, this is for ease of description. The first inclined area, the flat area, and the second inclined area may be substantially and smoothly connected to each other to form a curved surface. A plurality of cam crests 5112 may be formed. For example, the cam crest 5112 may include a first cam crest 5112a, a second cam crest 5112b, and a third cam crest 5112c. The plurality of cam crests 5112 may be spaced apart from each other along the circumference of the through hole 5111. For example, a trough may be substantially formed between the plurality of cam crests 5112.

In an embodiment, the body portion 512 may be a portion to which the arm bracket 520 is slidably (e.g., rotatably) connected. For example, a first recessed rail 5121 may be formed in the body portion 512. The arm bracket 520 may be slidably connected to the first recessed rail 5121. For example, the first recessed rail 5121 may interoperate with a first protruding rail (e.g., a first protruding rail 522 of FIG. 11) of the arm bracket 520. For example, the first recessed rail 5121 may be recessed in a rail shape in the body portion 512. The first recessed rail 5121 may be substantially formed in a straight line or curved to have a curvature. For example, the first recessed rail 5121 may include an arc shape having a third axis (e.g., the third axis A3 of FIG. 5) as the center.

In an embodiment, the connecting portion 513 may be a portion that connects the cam portion 511 to the body portion 512. For example, the cam portion 511, the connecting portion 513, and the body portion 512 may be connected to each other in a direction (e.g., X direction) perpendicular to a second axis (e.g., the second axis A2 of FIG. 5). The thickness (e.g., a thickness in a Z direction) of the connecting portion 513 may be less than the thickness of the cam portion 511 and/or the body portion 512 to avoid physical interference with a hinge housing (e.g., the hinge housing 313 of FIG. 17A). The first cam crest 5112a of the plurality of cam crests 5112 may be formed in an area adjacent to the connecting portion 513. At least a partial area of the first cam crest 5112a of the plurality of cam crests 5112 may be positioned to be aligned with the connecting portion 513 when viewed in the direction (e.g., X direction) substantially perpendicular to the second axis (e.g., the second axis A2 of FIG. 5) (e.g., an axis in the Y direction). For example, at least a partial area of the first cam crest 5112a of the plurality of cam crests 5112 may overlap or be aligned with the connecting portion 513 when viewed in the X direction perpendicular to the second axis A2. For example, the first cam crest 5112a may overlap or be aligned with the connecting portion 513 such that at least a portion of the first cam crest 5112a is connected to the body portion 512 when viewed in the direction (e.g., X direction) substantially perpendicular to the second axis A2 (e.g., the axis in the Y direction). For example, the entirety or a portion of the flat area of the first cam crest 5112a may overlap or be aligned with the connecting portion 513 when viewed in the direction (e.g., X direction) substantially perpendicular to the second axis A2 (e.g., the axis in the Y direction). For example, the first cam crest 5112a and the connecting portion 513 may be substantially formed as one. For example, the trough portions on both sides of the first cam crest 5112a may be referred to as a first cam trough 5113a and a second cam trough 5113b, respectively. In this case, the first cam trough 5113a and the second cam trough 5113b may not overlap or may not be aligned with the connecting portion 513 when viewed in the direction (e.g., X direction) perpendicular to the second axis A2 (e.g., the axis in the Y direction). For example, the connecting portion 513 may directly connect at least a partial area (e.g., the entirety of the flat area) of the first cam crest 5112a of the plurality of cam crests 5112 to the body portion 512. For example, the connecting portion 513 may connect the cam portion 511 to the body portion 512 at a portion (e.g., a portion of the first cam crest 5112a) of the cam portion 511 with the thickest width (e.g., the width in the Y direction). For example, the first cam trough 5113a and the second cam trough 5113b on both sides of the first cam crest 5112a may not be directly connected to the connecting portion 513. In this structure, the width (e.g., the width in the Y direction) of the connecting portion 513 may be relatively thicker than when the connecting portion 513 overlaps or is aligned with a trough area of the cam portion 511. Because the connecting portion 513 is a portion that connects the cam portion 511 to the body portion 512, stress may be concentrated on the connecting portion 513 during the operation of the hinge assembly 400. The width (e.g., the width in the Y direction) of the connecting portion 513 may be increased by forming the first cam crest 5112a and the connecting portion 513 to overlap or be aligned with each other. Thus, the strength of the connecting portion 513 may be increased and the occurrence of damage to the arm member 510 may be reduced.

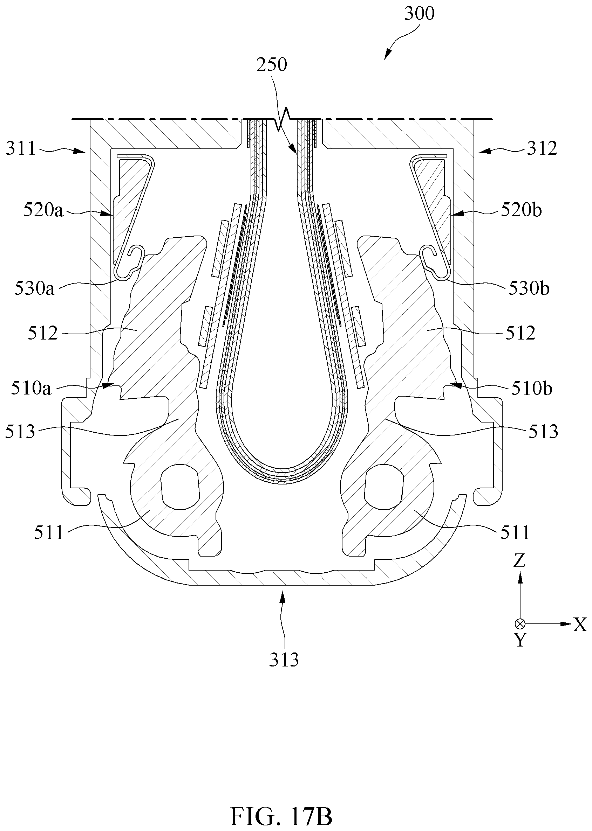

In an embodiment, the distance from the center of the through hole 5111 to the upper area (e.g., an area in a +Z direction) of the cam portion 511 may be less than the distance from the center of the through hole 5111 to another area (e.g., an area in a -Z direction). For example, based on a state in which the hinge assembly 400 is applied to an electronic device (e.g., the electronic device 300 of FIG. 17A), the distance from the center of the through hole 5111 to a first area (e.g., an area in the +Z direction) adjacent to a display (e.g., the display 250 of FIG. 17A) of the cam portion 511 may be less than the distance from the center of the through hole 5111 to a second area (e.g., an area in the -Z direction) relatively far from the display 250. For example, a first distance R1 from the center of the through hole 5111 to a first outer edge P1 of the cam portion 511 adjacent to the display 250 may be less than a second distance R2 from the center of the through hole 5111 to a second outer edge P2 of the cam portion 511 far from the display 250. For example, as illustrated in FIG. 7B, when a reference circle C1 corresponding to the area of the cam portion 511 in the -Z direction is drawn based on the center of the through hole 5111, the area of the cam portion 511 in the +Z direction may be positioned inside the reference circle C1. The size of at least a partial area of a cam crest (e.g., the first cam crest 5112a and/or the second cam crest 5112b) positioned on the upper area (e.g., the area in the +Z direction) of the plurality of cam crests 5112 may be less in a radial direction than the size of another cam crest (e.g., the third cam crest 5112c). For example, based on the state in which the hinge assembly 400 is applied to the electronic device (e.g., the electronic device 300 of FIG. 17A), the size of at least a partial area of a cam crest (e.g., the first cam crest 5112a and/or the second cam crest 5112b) of the plurality of cam crests 5112 adjacent to the display 250 may be less in the radial direction from the center of the through hole 5111 than the size of another cam crest (e.g., the third cam crest 5112c). For example, the size of a flat area of the cam crest (e.g., the first cam crest 5112a and/or the second cam crest 5112b) of the plurality of cam crests 5112 adjacent to the display 250 may be less than the size of a flat area of another cam crest (e.g., the third cam crest 5112c). As illustrated in FIGS. 17A and 17B, this structure may prevent interference between the cam portion 511 and the display 250 and may position the cam portion 511 closer to the display 250. For example, as illustrated in FIG. 17B, when the electronic device 300 is folded, because there is a spacing between the cam portion 511 and the display 250, collision between the cam portion 511 and the display 250 may be prevented. Because the cam portion 511 may be closer to the display 250, the sizes (e.g., thicknesses in the Z direction) of the hinge assembly 400 and the electronic device 300 including the hinge assembly 400 may be decreased.

In an embodiment, the connecting portion 513 may be formed at or below (e.g., -Z direction) a reference line L1 in the tangential direction of an end in an upward direction (e.g., an end in the +Z direction) of the cam portion 511. For example, based on the state in which the hinge assembly 400 is applied to the electronic device (e.g., the electronic device 300 of FIG. 17A), the connecting portion 513 may be formed at or below the reference line L1 parallel to the display 250 and passing through a point (e.g., an end point in the +Z direction) on the outer edge (e.g., P1) of the cam portion 511 adjacent to the display (e.g., the display 250 of FIG. 17B). For example, the connecting portion 513 may be formed at or below (e.g., -Z direction) the reference line L1 (e.g., the reference line L1 parallel to the display 250 and passing through a point on the outer edge of the second cam crest 5112b) in the tangential direction of the second cam crest 5112b adjacent to the display 250 among the plurality of cam crests 5112. A depression 5131 may be formed in the connecting portion 513 to avoid inference with the display 250. For example, the connecting portion 513 may be at least partially depressed in the -Z direction such that the depression 5131 is formed. The depression 5131 may be a portion that prevents the connecting portion 513 from being interfered with the display 250 when the electronic device 300 is folded. As illustrated in FIGS. 17A and 17B, this structure may prevent interference between the connecting portion 513 and the display 250 and may position the connecting portion 513 closer to the display 250. For example, as illustrated in FIG. 17B, when the electronic device 300 is folded, because there is a spacing (e.g., the depression 5131) between the connecting portion 513 and the display 250, a collision between the connecting portion 513 and the display 250 may be prevented. Because the connecting portion 513 may be closer to the display 250, the sizes (e.g., thicknesses in the Z direction) of the hinge assembly 400 and the electronic device 300 including the hinge assembly 400 may be reduced.

In an embodiment, the width W1 (e.g., the width in the Y direction) of the connecting portion 513 may be equal to or greater than the width W3 (e.g., the width in the Y direction) of the cam portion 511. For example, the minimum width W3 (e.g., the width in the Y direction) of the cam portion 511 may be equal to or less than the width W1 (e.g., the width in the Y direction) of the connecting portion 513. By forming the width W1 (e.g., the width in the Y direction) of the connecting portion 513 relatively large, it may be possible to increase the rigidity of the connecting portion 513. By forming the width W1 (e.g., the width in the Y direction) of the connecting portion 513 relatively larger than the width W3 (e.g., the width in the Y direction) of the cam portion 511, the connecting portion 513 may function as a stopper that prevents an arm bracket (e.g., the arm bracket 520 of FIG. 4) from excessively rotating with respect to the arm member 510. For example, the width W1 (e.g., the width in the Y direction) of the connecting portion 513 may be about 4 to 5 millimeters (mm). For example, the width W1 (e.g., the width in the Y direction) of the connecting portion 513 may be about 4.6 mm. For example, the minimum width W3 (e.g., the width in the Y direction) of the cam portion 511 may be about 2 to 3 mm. For example, the minimum width W3 (e.g., the width in the Y direction) of the cam portion 511 may be about 2.2 mm. For example, the width W2 (e.g., the width in the Y direction) of the cam portion 511 including the cam crest 5112 may be about 2.5 to 3.5 mm. For example, the width W2 (e.g., the width in the Y direction) of the cam portion 511 including the cam crest 5112 may be about 2.8 mm. For example, the thickness D1 (e.g., the thickness in the Z direction) from the lowest point (e.g., P2) to the highest point (e.g., P1) of the cam portion 511 may be about 3 to 4 mm. For example, the thickness D1 (e.g., the thickness in the Z direction) from the lowest point (e.g., P2) to the highest point (e.g., P1) of the cam portion 511 may be about 3.7 mm. For example, the thickness D2 (e.g., the thickness in the Z direction) of the connecting portion 513 may be about 0.5 to 1 mm. For example, the thickness D2 (e.g., the thickness in the Z direction) of the connecting portion 513 may be about 0.8 mm. For example, the thickness D3 (e.g., the thickness in the Z direction) of a portion adjacent to the connecting portion 513 of the body portion 512 may be about 3 to 4 mm. For example, the thickness D3 (e.g., the thickness in the Z direction) of the portion adjacent to the connecting portion 513 of the body portion 512 may be about 3.1 mm. For example, the maximum distance D4 (e.g., the distance in the Z direction) between the reference line L1 in the tangential direction of the highest point (e.g., P1) of the cam portion 511 and the connecting portion 513 may be about 0.5 to 1.5 mm. For example, the maximum distance D4 (e.g., the distance in the Z direction) between the reference line L1 in the tangential direction of the highest point (e.g., P1) of the cam portion 511 and the connecting portion 513 may be about 0.9 mm. However, this is an example, and the width and/or thickness of each portion is not limited thereto. For example, when the total size of the arm member 510 is changed, the width and/or thickness of each portion may be changed to the extent that a relative proportion is maintained.

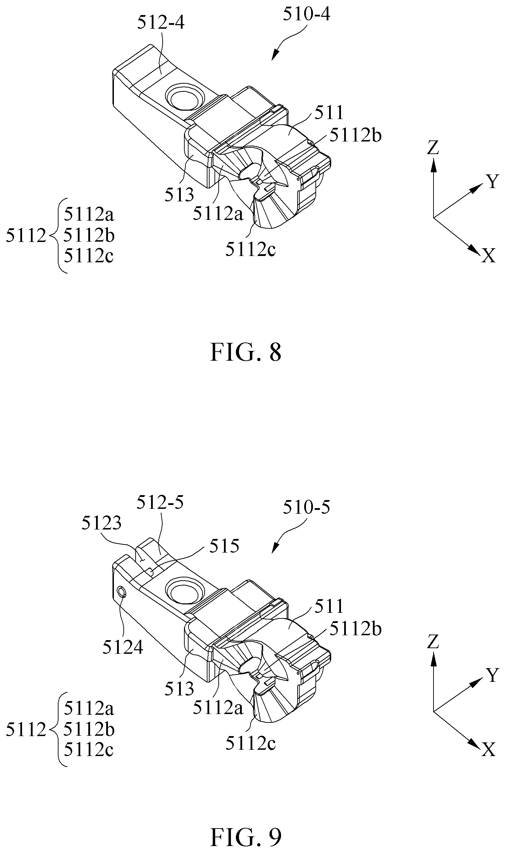

FIG. 8 is a perspective view of an arm member according to an embodiment.

Referring to FIG. 8, an arm member 510-4 according to an embodiment may include the cam portion 511, a body portion 512-4, and the connecting portion 513. The cam portion 511 may include the cam crest 5112. For example, the cam crest 5112 may include a first cam crest 5112a, a second cam crest 5112b, and a third cam crest 5112c. The connecting portion 513 may connect the body portion 512-4 to the cam portion 511. The body portion 512-4 may be a portion to which an arm bracket (e.g., the arm bracket 520 of FIG. 4) is slidably connected. For example, the arm bracket 520 may include a structure to which the body portion 512-4 is slidably connected. For example, the arm bracket 520 may include a recessed rail. The body portion 512-4 may be inserted into and slide along the recessed rail. As the body portion 512-4 slides along the recessed rail formed on the arm bracket 520, the arm member 510-4 may slide and move with respect to the arm bracket 520.

FIG. 9 is a perspective view of an arm member according to an embodiment.

Referring to FIG. 9, an arm member 510-5 according to an embodiment may include the cam portion 511, a body portion 512-5, the connecting portion 513, and a pin member 515. The cam portion 511 may include the cam crest 5112. For example, the cam crest 5112 may include the first cam crest 5112a, the second cam crest 5112b, and the third cam crest 5112c. The connecting portion 513 may connect the body portion 512-5 to the cam portion 511. The body portion 512-5 may be a portion to which an arm bracket (e.g., the arm bracket 520 of FIG. 4) is slidably connected. For example, a cut space 5123 may be formed on one side (e.g., a portion in the -X direction) of the body portion 512-5 by partially cutting the body portion 512-5. A pin insertion hole 5124 that passes through the body portion 512-5 in the direction parallel to the second axis (e.g., the second axis A2 of FIG. 5 (e.g., the axis in the Y direction)) may be formed on one side (e.g., the portion in the -X direction) of the body portion 512-5. The pin insertion hole 5124 may pass through the cut space 5123. The pin member 515 may be inserted into the pin insertion hole 5124. For example, the arm bracket (e.g., the arm bracket 520 of FIG. 4) may include a structure to which the body portion 512-5 is slidably connected. For example, a cut rail may be formed on the arm bracket 520, allowing the pin member 515 to slide. For example, when the cut rail formed on the arm bracket 520 is positioned in the cut space 5123 of the body portion 512-5, the pin member 515 may be inserted into the pin insertion hole 5124. As the pin member 515 slides along the cut rail formed on the arm bracket 520, the arm member 510-5 may slide and move with respect to the arm bracket 520. The arm members 510, 510-4, and 510-5 illustrated with reference to FIGS. 7A to 7C, 8, and 9 are examples. Thus, in an embodiment, an arm member may be slidably connected to an arm bracket through various structures.

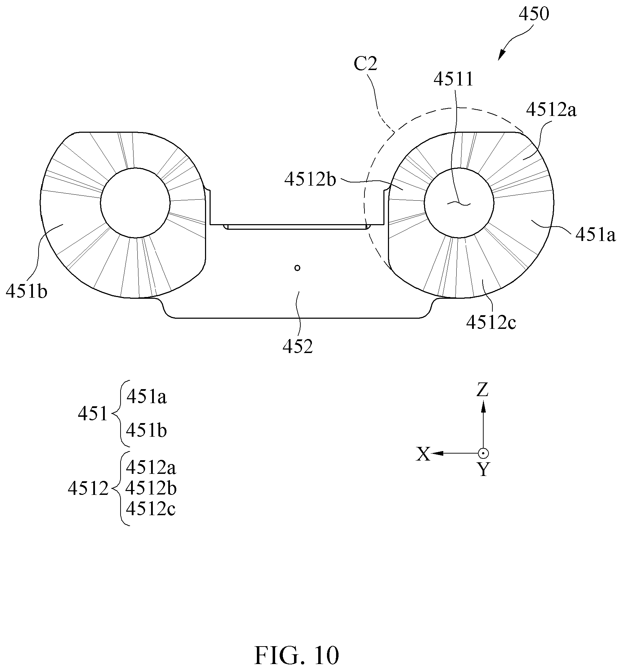

FIG. 10 is a front view illustrating a cam member according to an embodiment.

Referring to FIGS. 4 to 7C, and 10, in an embodiment, the cam member 450 may include a fixed cam portion 451 and a connecting body 452. The fixed cam portion 451 may be formed to substantially correspond to the cam portion 511 of the arm member 510. The fixed cam portion 451 may be a portion in which a through hole 4511 and a fixed cam crest 4512 are formed. The through hole 4511 may be a hole to which the shaft 420 is inserted. The fixed cam crest 4512 may be formed in the direction (e.g., +Y direction) toward the cam crest 5112 of the arm member 510. For example, the shape of the fixed cam crest 4512 may be substantially the same as the shape of the cam crest 5112 of the arm member 510. The fixed cam crest 4512 may be formed to have a profile with a first inclined area, a flat area, and a second inclined area. However, this is for ease of description. The first inclined area, the flat area, and the second inclined area may be substantially and smoothly connected to one another to form a curved surface. A plurality of fixed cam crests 4512 may be formed. For example, the fixed cam crest 4512 may include a first fixed cam crest 4512a, a second fixed cam crest 4512b, and a third fixed cam crest 4512c. The plurality of fixed cam crests 4512 may be spaced apart from each other along the circumference of the through hole 4511. For example, a trough may be formed between the plurality of fixed cam crests 4512. Based on a state in which the hinge assembly 400 is fully unfolded or folded, the plurality of fixed cam crests 4512 may be positioned in a trough portion between the plurality of cam crests 5112 of the arm member 510. When the hinge assembly 400 is in an intermediate state, the plurality of fixed cam crests 4512 may be positioned such that the plurality of cam crests 5112 of the arm member 510 is in contact with a crest portion. A pair of fixed cam portions 451 may be formed. For example, the fixed cam portion 451 may include a first fixed cam portion 451a and a second fixed cam portion 451b. The first shaft 420a and the second shaft 420b may be inserted into the first fixed cam portion 451a and the second fixed cam portion 451b, respectively. Cam interoperation may be implemented between the first fixed cam portion 451a and the cam portion 511 of the first arm member 510a and between the second fixed cam portion 451b and the cam portion 511 of the second arm member 510b. The first fixed cam portion 451a may be connected to the second fixed cam portion 451b by the connecting body 452.

In an embodiment, the distance from the center of the through hole 4511 to an upper area (e.g., an area in the +Z direction) of the fixed cam portion 451 may be less than the distance from the center of the through hole 4511 to another area (e.g., an area in the -Z direction) of the fixed cam portion 451. For example, based on a state in which the hinge assembly 400 is applied to an electronic device (e.g., the electronic device 300 of FIG. 17A), the distance from the center of the through hole 4511 to an area (e.g., an area in the +Z direction) adjacent to a display (e.g., the display 250 of FIG. 17B) of the fixed cam portion 451 may be less than the distance from the center of the through hole 4511 to another area (e.g., an area in the -Z direction). For example, as illustrated in FIG. 10, when a reference circle C2 corresponding to the area in the -Z direction of the fixed cam portion 451 is drawn based on the center of the through hole 4511, the area in the +Z direction of the fixed cam portion 451 may be positioned inside the reference circle C2. The size of at least a partial area of a fixed cam crest (e.g., the first fixed cam crest 4512a and/or the second cam crest 4512b) positioned on an upper area (e.g., an area in the +Z direction) among the plurality of fixed cam crests 4512 may be less in a radial direction than the size of another fixed cam crest (e.g., the third fixed cam crest 4512c). For example, the size of at least a partial area of a fixed cam crest (e.g., the first fixed cam crest 4512a and/or the second fixed cam crest 4512b) adjacent to the display 250 among the plurality of fixed cam crests 4512 may be less than in the radial direction from the center of the through hole 4511 than the size of another fixed cam crest (e.g., the third fixed cam crest 4512c). This structure may prevent interference between the cam portion 450 and the display 250 and may position the cam portion 450 closer to the display 250. Because the cam portion 450 may be positioned closer to the display 250, the sizes (e.g., thicknesses in the Z direction) of the hinge assembly 400 and the electronic device 300 including the hinge assembly 400 may be reduced.

FIG. 11 is a perspective view illustrating a first arm bracket according to an embodiment.

Hereinafter, the arm bracket 520 is described based on the first arm bracket 520a with reference to FIGS. 4 to 7C and 11. The second arm bracket 520b may be substantially symmetrical to the first arm bracket 520a based on a folding axis (e.g., the folding axis A of FIG. 3).

In an embodiment, the arm bracket 520 may include an arm bracket body 521, a first protruding rail 522, and/or a fastener 523.

In an embodiment, the arm bracket body 521 may be a portion that forms the exterior of the arm bracket 520. For example, the arm bracket body 521 may include the first protruding rail 522 and/or at least one fastener 523. The first protruding rail 522 may interoperate with the first recessed rail 5121 of the arm member 510. The arm bracket 520 may slide (e.g., rotate) with respect to the arm member 510 by interoperation between the first recessed rail 5121 and the first protruding rail 522. The first protruding rail 522 may be formed in a shape corresponding to the first recessed rail 5121. For example, the first protruding rail 522 may be formed by protruding in a rail shape from a space in which the arm bracket body 521, to which the arm member 510 is inserted, is recessed. The fastener 523 may be a hole for connecting the arm bracket 520 to a first housing (e.g., the first housing 311 of FIG. 3) or a second housing (e.g., the second housing 312 of FIG. 3).

FIG. 12 is a perspective view of a first wing member according to an embodiment.

Hereinafter, the wing member 610 is described based on the first wing member 610a with reference to FIGS. 4 to 6, and 12. The second wing member 610b may be substantially the same as the first wing member 610a.

In an embodiment, the wing member 610 may include a wing member body 611, the recessed guide rail 612, a second recessed rail 613, and/or a fastener 614.

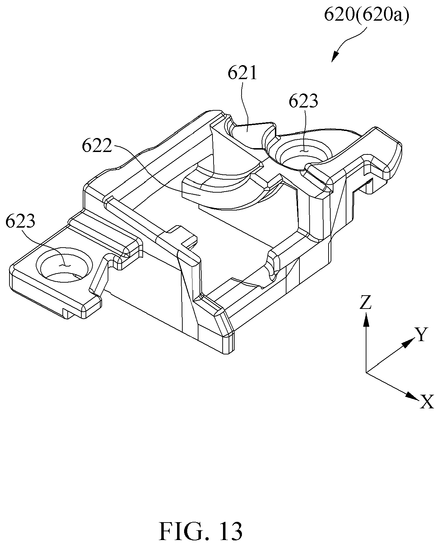

In an embodiment, the wing member body 611 may be a portion that forms the exterior of the wing member 610. For example, the wing member body 611 may include the recessed guide rail 612, the second recessed rail 613, and/or at least one fastener 614. The recessed guide rail 612 may interoperate with the protruding guide rail 413 of the hinge bracket 410. The wing member 610 may rotate with respect to the hinge bracket 410 by interoperation between the recessed guide rail 612 and the protruding guide rail 413. The recessed guide rail 612 may be formed in a shape corresponding to the protruding guide rail 413. For example, the recessed guide rail 612 may be formed by being recessed in a rail shape on one side (e.g., a portion in the +X direction) of the wing member body 611. The second recessed rail 613 may be a component for slidably connecting the wing member 610 to the wing bracket 620. The second recessed rail 613 may interoperate with a second protruding rail (e.g., the second protruding rail 622 of FIG. 13) of the wing bracket 620. For example, the second recessed rail 613 may be curved to have a curvature. For example, the second recessed rail 613 may include an arc shape having a fourth axis (e.g., the fourth axis A4 of FIG. 5) as the center. For example, the second recessed rail 613 may be recessed in a rail shape on the other side (e.g., a portion in the -X direction) of the wing member body 611. The fastener 614 may be a hole for connecting a wing plate (e.g., the wing plate 630 of FIG. 14A) to the wing member 610.

FIG. 13 is a perspective view illustrating a first wing bracket according to an embodiment.

Hereinafter, the wing bracket 620 is described based on the first wing bracket 620a with reference to FIGS. 4 to 6, 12, and 13. The second wing bracket 620b may be substantially symmetrical to the first wing bracket 620a based on a folding axis (e.g., the folding axis A of FIG. 3).

In an embodiment, the wing bracket 620 may include a wing bracket body 621, the second protruding rail 622, and/or a fastener 623.

In an embodiment, the wing bracket body 621 may be a portion that forms the exterior of the wing bracket 620. For example, the wing bracket body 621 may include the second protruding rail 622 and/or at least one fastener 623. The second protruding rail 622 may interoperate with the second recessed rail 613 of the wing member 610. The wing bracket 620 may slide (e.g., rotate) with respect to the wing member 610 by interoperation between the second recessed rail 613 and the second protruding rail 622. The second protruding rail 622 may be formed in a shape corresponding to the second recessed rail 613. For example, the second protruding rail 622 may be formed by protruding in a rail shape from a space in which the wing bracket body 621, to which the wing member 610 is inserted, is recessed. The fastener 623 may be a hole for connecting the wing bracket 620 to a first housing (e.g., the first housing 311 of FIG. 3) or a second housing (e.g., the second housing 312 of FIG. 3).

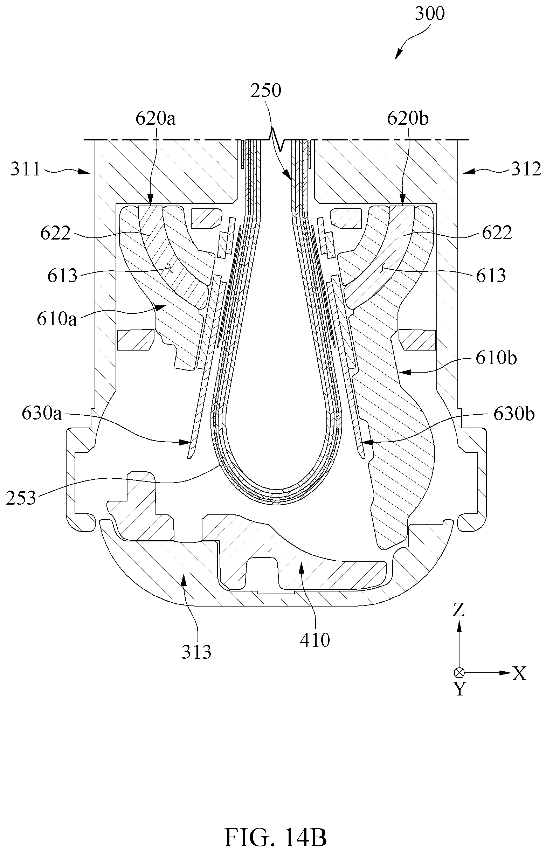

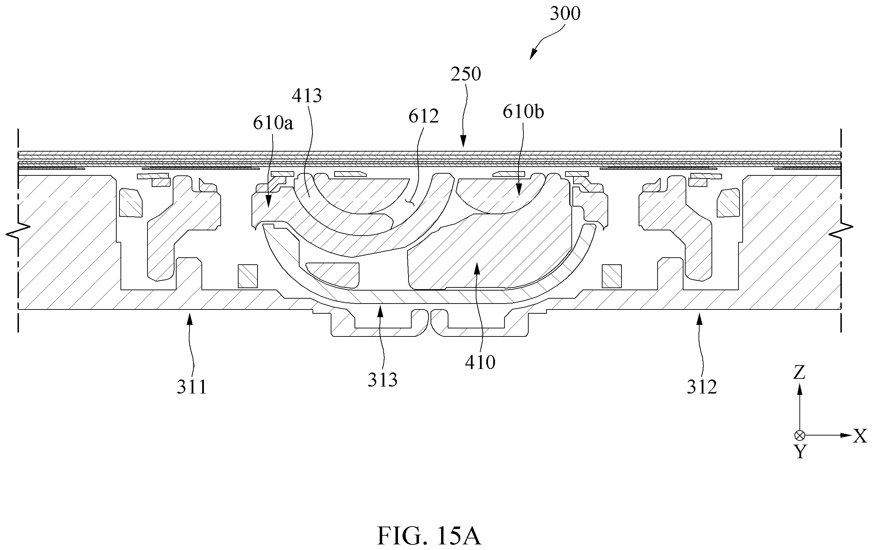

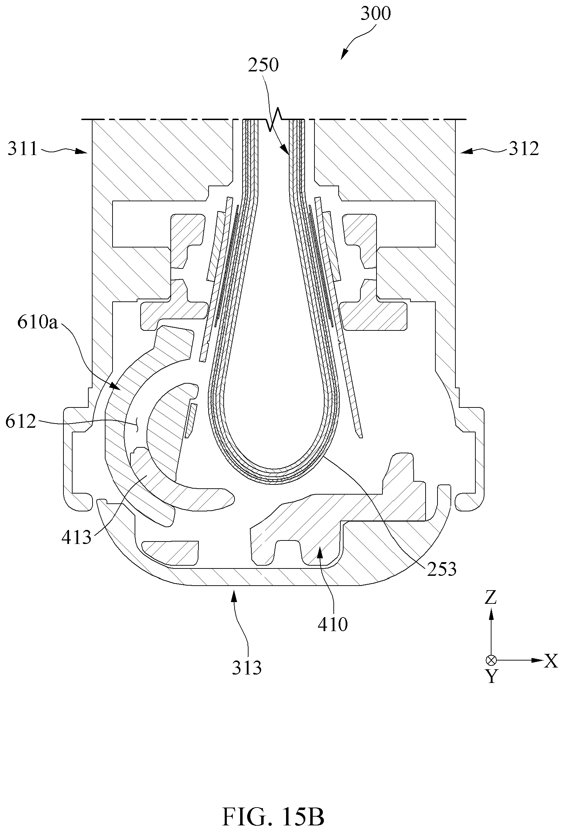

FIG. 14A is a partial cross-sectional view taken along the line I-I in FIG. 5 with an electronic device in an unfolded state, based on a state in which a hinge assembly is applied to the electronic device, according to an embodiment. FIG. 14B is a partial cross-sectional view taken along the line I-I in FIG. 5 with the electronic device in a folded state, based on a state in which the hinge assembly is applied to the electronic device, according to an embodiment. FIG. 15A is a partial cross-sectional view taken along the line II-II in FIG. 5 with an electronic device in an unfolded state, based on a state in which a hinge assembly is applied to the electronic device, according to an embodiment. FIG. 15B is a partial cross-sectional view taken along the line II-II in FIG. 5 with the electronic device in a folded state, based on a state in which the hinge assembly is applied to the electronic device, according to an embodiment.

Referring to FIGS. 14A to 15B, in an embodiment, the hinge bracket 410 may be fixedly connected to the hinge housing 313. A wing member (e.g., 610a and 610b) may be rotatably connected to the hinge bracket 410 by interoperation between the protruding guide rail 413 and the recessed guide rail 612. During the folding or unfolding process of the electronic device 300, the wing member (e.g., 610a and 610b) may rotate with respect to the hinge bracket 410 along the path of the protruding guide rail 413 and the recessed guide rail 612. A wing plate (e.g., 630a and 630b) may be connected to the wing member (e.g., 610a and 610b). The wing plate (e.g., 630a and 630b) may support the display 250. Until the electronic device 300 in a fully unfolded state is fully folded, the wing member (e.g., 610a and 610b) and the wing plate (e.g., 630a and 630b) may rotate 90 degrees or more (e.g., about 105 degrees) with respect to the hinge bracket 410. With this structure, when the electronic device 300 is fully folded, the folding area 253 of the display 250 may be folded in a shape resembling a water droplet. Allowing the folding area 253 of the display 250 to be folded in a shape resembling a water droplet when the electronic device 300 is folded may reduce damage to the folding area 253 of the display 250 and decrease the gap between the first housing 311 and the second housing 312.

In an embodiment, a wing bracket (e.g., 620a and 620b) may be rotatably connected to the wing member (e.g., 610a and 610b), respectively, by interoperation between the second recessed rail 613 and the second protruding rail 622. The first housing 311 and the second housing 312 may be connected to the first wing bracket 620a and the second wing bracket 620b, respectively. During the folding or unfolding process of the electronic device 300, the wing bracket (e.g., 620a and 620b) may rotate with respect to the wing member (e.g., 610a and 610b) along the path of the second recessed rail 613 and the second protruding rail 622. Until the electronic device 300 in a fully unfolded state is fully folded, the first housing 311 and the second housing 312 may rotate about 90 degrees, while the wing member (e.g., 610a and 610b) may rotate 90 degrees or more. Thus, the wing bracket (e.g., 620a and 620b) may rotate with respect to the wing member (e.g., 610a and 610b) by an angle difference in the direction opposite to the rotation direction of the wing member (e.g., 610a and 610b). For example, while the electronic device 300 transitions from being fully unfolded to fully folded, the first wing member 610a may rotate clockwise with respect to the hinge bracket 410 and the first wing bracket 620a may rotate counterclockwise with respect to the first wing member 610a.

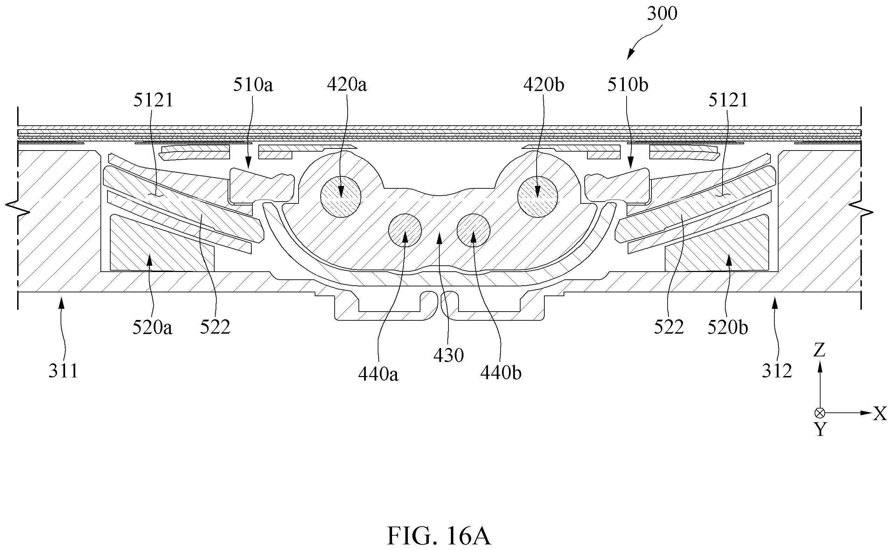

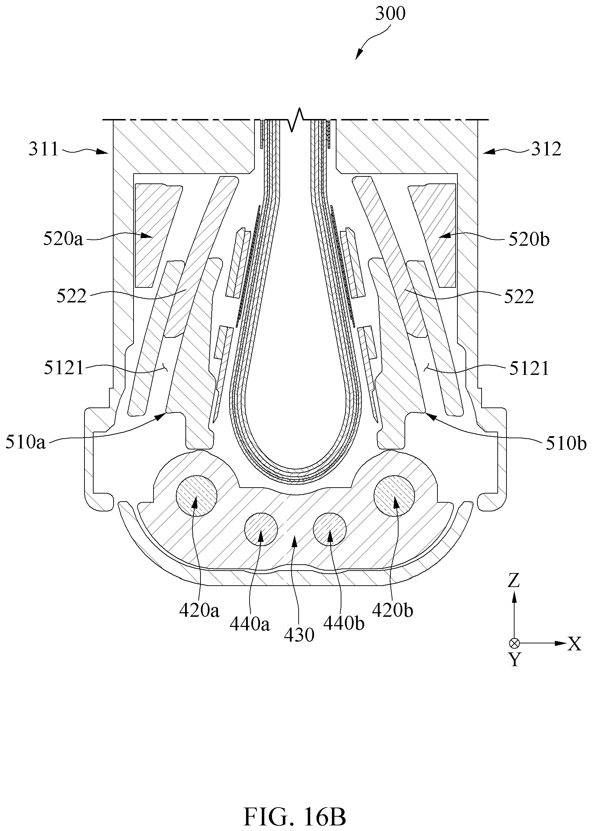

FIG. 16A is a partial cross-sectional view taken along the line III-III in FIG. 5 with an electronic device in an unfolded state, based on a state in which a hinge assembly is applied to the electronic device, according to an embodiment. FIG. 16B is a partial cross-sectional view taken along the line III-III in FIG. 5 with the electronic device in a folded state, based on a state in which the hinge assembly is applied to the electronic device, according to an embodiment. FIG. 17A is a partial cross-sectional view taken along the line IV-IV in FIG. 5 with an electronic device in an unfolded state, based on a state in which a hinge assembly is applied to the electronic device, according to an embodiment. FIG. 17B is a partial cross-sectional view taken along the line IV-IV in FIG. 5 with the electronic device in a folded state, based on a state in which the hinge assembly is applied to the electronic device, according to an embodiment.

Referring to FIGS. 16A to 17B, during the folding or unfolding process of the electronic device 300, an arm member (e.g., 510a and 510b) may rotate with respect to a hinge bracket (e.g., the hinge bracket 410 of FIG. 14A) together with a shaft (e.g., 420a and 420b). The rotation motion of the first shaft 420a may interoperate with the rotation motion of the second shaft 420b through an idle gear (e.g., 440a and 440b). The idle gear (e.g., 440a and 440b) may rotate between the first shaft 420a and the second shaft 420b with respect to the gear bracket 430 and synchronize the rotation motion of the first shaft 420a with the rotation motion of the second shaft 420b. An arm bracket (e.g., 520a and 520b) may be rotatably connected to the arm member (e.g., 510a and 510b) by interoperation between the first recessed rail 5121 and the first protruding rail 522. The first housing 311 and the second housing 312 may be connected to the first arm bracket 520a and the second arm bracket 520b, respectively. During the folding or unfolding process of the electronic device 300, the arm bracket (e.g., 520a and 520b) may rotate with respect to the arm member (e.g., 510a and 510b) along the path of the first recessed rail 5121 and the first protruding rail 522. For example, until the electronic device 300 in a fully unfolded state is fully folded, the arm member (e.g., 510a and 510b) may rotate 90 degrees or less (e.g., about 85 degrees) with respect to the hinge bracket 410. On the other hand, until the electronic device 300 in a fully unfolded state is fully folded, the first housing 311 and the second housing 312 may rotate about 90 degrees. Thus, the arm bracket (e.g., 520a and 520b) may rotate with respect to the arm member (e.g., 510a and 510b) by an angle difference in the same direction as the rotation direction of the arm member (e.g., 510a and 510b). For example, while the electronic device 300 transitions from being fully unfolded to fully folded, the first arm member 510a may rotate clockwise with respect to the hinge bracket 410 and the first arm bracket 520a may rotate counterclockwise with respect to the first arm member 510a. For example, while the electronic device 300 transitions from being fully unfolded to fully folded, a wing member (e.g., 610a and 610b) may rotate 90 degrees or more with respect to the hinge bracket 410 and an arm member (e.g., 510a and 510b) may rotate 90 degrees or less with respect to the hinge bracket 410. Thus, the first recessed rail 5121 and the second recessed rail 613 may be formed to have curvatures in opposite directions such that the first housing 311 and the second housing 312 may rotate about 90 degrees.

In an embodiment, an elastic member (e.g., 530a and 530b) may be positioned between the arm bracket (e.g., 520a and 520b) and the arm member (e.g., 510a and 510b). The elastic member (e.g., 530a and 530b) may be inserted into a space formed in the arm bracket (e.g., 520a and 520b) and may apply pressure to the body portion 512 against the arm bracket (e.g., 520a and 520b). For example, the elastic member (e.g., 530a and 530b) may include a plate spring. The elastic member (e.g., 530a and 530b) may increase the frictional force between the first recessed rail 5121 and the first protruding rail 522 through pressing force. The frictional force between the first recessed rail 5121 and the first protruding rail 522 may have an impact on detent force and/or free-stop force of the hinge assembly (e.g., the hinge assembly 400 of FIG. 4). As described above with reference to FIG. 7B, when the size of a flat area of a cam crest (e.g., the first cam crest 5112a and/or the second cam crest 5112b) adjacent to the display 250 among the plurality of cam crests 5112 is less than the size of a flat area of another cam crest (e.g., the third cam crest 5112c), a rotational torque may decrease as the size of the flat area decreases. In this case, an increase in the elasticity of the elastic member (e.g., 530a and 530b) may compensate for the decrease in the rotational torque. For example, as the pressing force of the elastic member (e.g., 530a and 530b) increases, the frictional force between the first recessed rail 5121 and the first protruding rail 522 increases. Thus, the detent force and/or the free-stop force of the hinge assembly 400 may increase. When the pressing force of the elastic member (e.g., 530a and 530b) increases, a groove (e.g., a groove 5122 of FIG. 7C) may be formed in the body portion 512 touching the elastic member (e.g., 530a and 530b) such that the pressing force of elastic member (e.g., 530a and 530b) may disperse. For example, the groove 5122 may be formed in the direction (e.g., -Z direction) perpendicular to the rotation axis (e.g., Y direction) of the arm member 510. As the groove 5122 is formed in the body portion 512, an end of the elastic member (e.g., 530a and 530b) may be in contact with at least two areas of the body portion 512. With this structure, the pressing force of the elastic member (e.g., 530a and 530b) may be dispersed and applied to a surface of the body portion 512, decreasing the possibility that the elastic member (e.g., 530a and 530b) and/or the body portion 512 is damaged.

In an embodiment, the first recessed rail 5121 is described as being recessed into the arm member 510 and the first protruding rail 522 is described as protruding from the arm bracket 520. However, this is only an example, and it is obvious to one of ordinary skill in the art that a rail may protrude from the arm member 510 and a rail may be recessed into the arm bracket 520. In another example, the second recessed rail 613 is described as being recessed into the wing member 610 and the second protruding rail 622 is described as protruding from the wing bracket 620. However, this is only an example, and it is obvious to one of ordinary skill in the art that a rail may protrude from the wing member 610 and a rail may be recessed into the wing bracket 620. In another example, the recessed guide rail 612 is described as being recessed into the wing member 610 and the protruding guide rail 413 is described as protruding from the hinge bracket 410. However, this is only an example, and it is obvious to one of ordinary skill in the art that a rail may protrude from the wing member 610 and a rail may be recessed into the hinge bracket 410. In addition, a structure causing two components to slide against each other is not limited to a rail structure. Any structure causing two components to slide against each other may be used (e.g., FIG. 8 or 9).

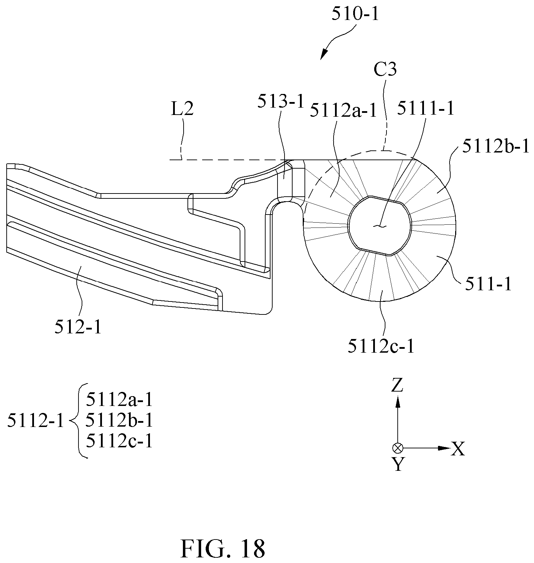

FIG. 18 is a front view illustrating an arm member according to an embodiment.

Referring to FIG. 18, an arm member 510-1 according to an embodiment may include a cam portion 511-1, a body portion 512-1, and a connecting portion 513-1. For example, the cam portion 511-1, the connecting portion 513-1, and the body portion 512-1 may be connected to one another in the direction (e.g., X direction) perpendicular to a second axis (e.g., the second axis A2 of FIG. 5). The cam portion 511-1 may include a through hole 5111-1 and a cam crest 5112-1. For example, the cam crest 5112-1 may include a first cam crest 5112a-1, a second cam crest 5112b-1, and a third cam crest 5112c-1. The distance from the center of the through hole 5111-1 to the upper area (e.g., an area in the +Z direction) of the cam portion 511-1 may be less than the distance from the center of the through hole 5111-1 to another area (e.g., an area in the -Z direction) of the cam portion 511-1. For example, based on a state in which a hinge assembly (e.g., the hinge assembly 400 of FIG. 4) is applied to an electronic device (e.g., the electronic device 300 of FIG. 17A), the distance from the center of the through hole 5111-1 to an area (e.g., the area in the +Z direction) of the cam portion 511-1 adjacent to a display (e.g., the display 250 of FIG. 17A) may be less than the distance from the center of the through hole 5111-1 to another area (e.g., the area in the +Z direction) of the cam portion 511-1. For example, as illustrated in FIG. 18, when a reference circle C3 corresponding to the area in the -Z direction of the cam portion 511-1 is drawn based on the center of the through hole 5111-1, the area in the +Z direction of the cam portion 511-1 may be positioned inside the reference circle C3. For example, the area in the +Z direction of the cam portion 511-1 may be substantially formed in a planar shape. The connecting portion 513-1 may be formed at or below the reference line L2 parallel to the display 250 and passing through a point (e.g., an end point in the +Z direction) on the outer edge of cam portion 511-1 adjacent to the reference line L2 (e.g., a display (e.g., the display 250 of FIG. 17B)) in the tangential direction of an upper end (e.g., +Z direction) of the cam portion 511-1. The connecting portion 513-1 may be formed at or below (e.g., -Z direction) the reference line L2 of the area in the +Z direction of the cam portion 511-1. The first cam crest 5112a-1 of the plurality of cam crests 5112-1 may be formed in an area adjacent to the connecting portion 513-1. At least a partial area of the first cam crest 5112a-1 of the plurality of cam crests 5112-1 may overlap or be aligned with the connecting portion 513-1 when viewed in the direction (e.g., X direction) substantially perpendicular to the second axis (e.g., the second axis A2 of FIG. 5) (e.g., an axis in the Y direction). For example, the first cam crest 5112a-1 may overlap or be aligned with the connecting portion 513-1 such that at least a portion of the first cam crest 5112a-1 is connected to the connecting portion 513-1 when viewed in the direction (e.g., X direction) substantially perpendicular to the second axis A2 (e.g., the axis in the Y direction). For example, the entirety or a portion of the flat area of the first cam crest 5112a-1 may overlap or be aligned with the connecting portion 513-1 when viewed in the direction (e.g., X direction) substantially perpendicular to the second axis A2 (e.g., the axis in the Y direction). For example, the first cam crest 5112a-1 may be formed to have a larger area than the connecting portion 513-1. For example, both trough portions of the first cam crest 5112a-1 may not overlap or be aligned with the connecting portion 513-1 when viewed in the direction (e.g., X direction) substantially perpendicular to the second axis A2 (e.g., the axis in the Y direction). For example, the connecting portion 513-1 may directly connect at least a partial area (e.g., the entirety of the flat area) of the first cam crest 5112a-1 of the plurality of cam crests 5112-1 to the body portion 512-1. For example, the connecting portion 513-1 may connect the cam portion 511-1 to the body portion 512-1 at a portion (e.g., a portion of the first cam crest 5112a-1) of the cam portion 511-1 with the thickest width (e.g., the width in the Y direction). For example, a first cam trough and a second cam trough at both sides of the first cam crest 5112a-1 may not be directly connected to the connecting portion 513-1.

FIG. 19A is a front view illustrating a hinge assembly according to an embodiment. FIG. 19B is a partial side view illustrating the hinge assembly according to an embodiment.

Referring to FIGS. 19A and 19B, a pressing member 460-1 may include a plate spring. The pressing member 460-1 may be positioned between a shaft bracket 470 and the cam member 450. For example, the pressing member 460-1 may have one side (e.g., the side in the -Y direction) fixedly connected to the shaft bracket 470 and the other side (e.g., the side in the +Y direction) touching the cam member 450. The pressing member 460-1 may generate its own elastic force. The pressing member 460-1 may use its own elastic force to apply pressure to the cam member 450 toward the cam portion 511 of the arm member 510.

FIG. 20 is a front view illustrating a hinge assembly according to an embodiment.

Referring to FIG. 20, a pressing member 460-2 may include an actuator. For example, the pressing member 460-2 may include a motor and a power transmission member 461 to transmit the power of the motor. For example, the motor may engage with the power transmission member 461 through a gear. The pressing member 460-2 may generate force to apply pressure to the cam member 450 toward the cam portion 511 of the arm member 510. The power generated by the pressing member 460-2 may be transmitted to the cam member 450 through the power transmission member 461.

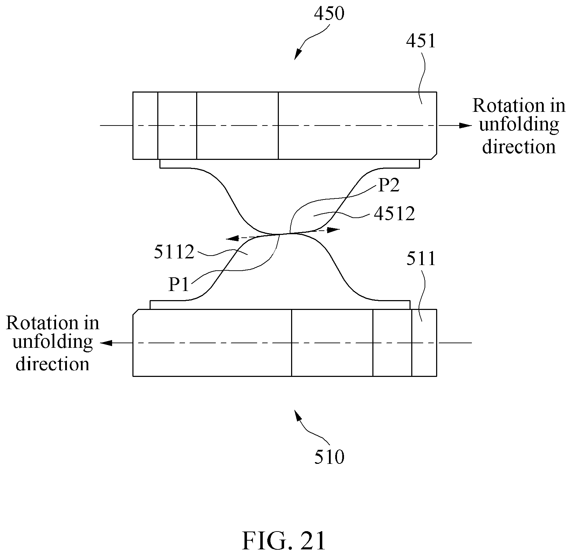

FIG. 21 is an enlarged view illustrating a cam portion of an arm member and a cam portion of a cam member, according to an embodiment.

Referring to FIG. 21, in an embodiment, the cam crest 5112 formed on the cam portion 511 of the arm member 510 may face the fixed cam crest 4512 formed on the fixed cam portion 451 of the cam member 450. Each of a flat area P1 of the cam crest 5112 and a flat area P2 of the fixed cam crest 4512 may be formed to have substantially an inclined angle. For example, based on the process of unfolding an electronic device (e.g., the electronic device 300 of FIG. 3) from a folded state, the flat area P1 of the cam crest 5112 and the flat area P2 of the fixed cam crest 4512 may each have an inclined angle such that a second side opposite to a first side is higher than the first side positioned on a side in the unfolding direction. For example, during the transition of the electronic device 300 from a folded state to an unfolded state, the cam portion 511 may rotate on a second axis A2 in a first rotation direction and the flat area of the cam crest 5112 may be inclined such that the second side positioned on the side in a second rotation direction opposite to the first rotation direction is higher than the first side positioned on the side in the first rotation direction. While the electronic device 300 transitions from being folded to unfolded, because the flat area P1 of the cam crest 5112 is in contact with the flat area P2 of the fixed cam crest 4512 at an inclined angle, the cam crest 5112 and the fixed cam crest 4512 may cancel at least some of repulsive or resilient force generated in the unfolding direction. Accordingly, a push in a free-stop state (e.g., a change in the angle between a first housing (e.g., the first housing 311 of FIG. 3) and a second housing (e.g., the second housing 312 of FIG. 3)) that may occur regardless of a user's intent may be prevented. When the electronic device 300 is in a cradling state (or a free-stop state) at a predetermined angle, the cam crest 5112 and the fixed cam crest 4512 may engage with each other and cancel repulsive or resilient force that makes the electronic device 300 to be unfolded. A structure in which the tops of both the cam crest 5112 and the fixed cam crest 4512 have inclined angles is described as an example with reference to FIG. 21. However, embodiments are not limited thereto. For example, either the cam crest 5112 or the fixed cam crest 4512, but not both, may have an inclined angle.

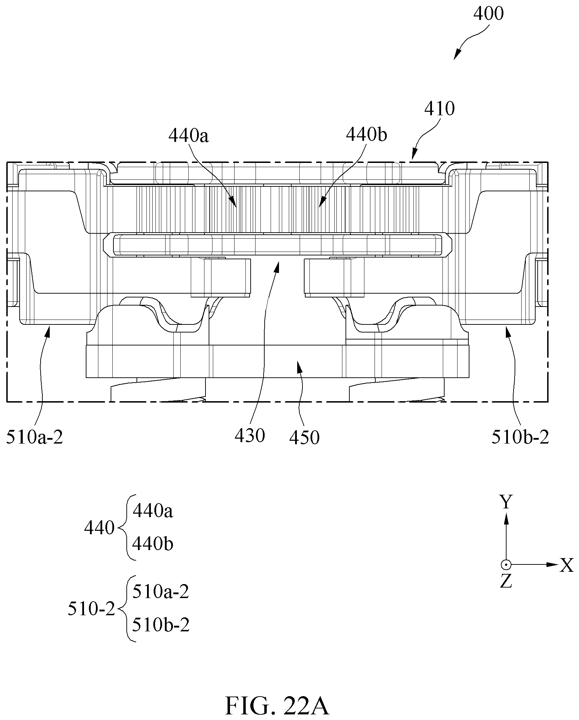

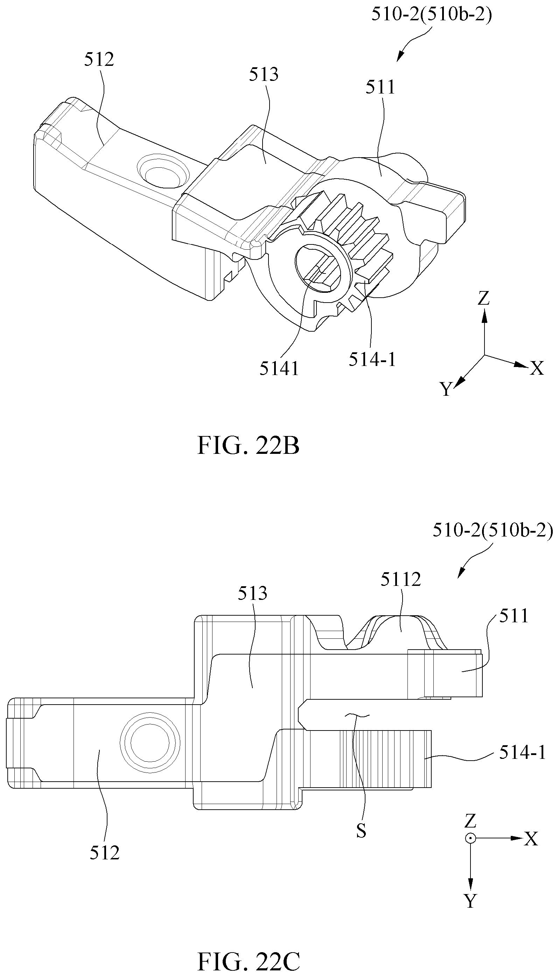

FIG. 22A is a partial front view illustrating a hinge assembly according to an embodiment. FIG. 22B is a perspective view of an arm member according to an embodiment. FIG. 22C is a plan view of the arm member according to an embodiment.

The descriptions provided with reference to FIGS. 4 to 17B may apply to the hinge assembly 400 and the arm member 510-2 described with reference to FIGS. 22A to 22C within a range that does not contradict for substantially the same configuration.

In an embodiment, the hinge assembly 400 may include the hinge bracket 410, the idle gear 440, the gear bracket 430, the arm member 510-2, and/or the cam member 450. The idle gear 440 may include a first idle gear 440a and a second idle gear 440b. The arm member 510-2 may include a first arm member 510a-2 and a second arm member 510b-2. Hereinafter, the arm member 510-2 is described based on the second arm member 510b-2. The first arm member 510a-2 may be substantially symmetrical to the second arm member 510b-2 based on a folding axis (e.g., the folding axis A of FIG. 3).

In an embodiment, the arm member 510-2 may include a cam structure and a gear structure. For example, the arm member 510-2 may include the cam portion 511, the body portion 512, the connecting portion 513, and the gear portion 514-1. The cam portion 511 may be a portion on which the cam crest 5112 is formed. The body portion 512 may be a portion to which an arm bracket (e.g., the arm bracket 520 of FIG. 4) is slidably connected. The gear portion 514-1 may be a portion having a gear structure. The gear portion 514-1 may be spaced apart from the cam portion 511. For example, the gear portion 514-1 may be positioned away from the cam portion 511 on the side (e.g., +Y direction) opposite to the surface (e.g., -Y direction) on which the cam crest 5112 is formed among the surfaces of the cam portion 511. For example, a spacing S may be formed between the gear portion 514-1 and the cam portion 511. A through hole 5141 to which a shaft (e.g., the shaft 420 of FIG. 4) is inserted may be formed near the center of the gear portion 514-1. The connecting portion 513 may be a portion that connects the cam portion 511, the gear portion 514-1, and the body portion 512 to one another. The cam portion 511 and the gear portion 514-1 may be positioned on one side (e.g., the side in the +X direction) of the connecting portion 513 and the body portion 512 may be positioned at the other side (e.g., the side in the -X direction) of the connecting portion 513.

In an embodiment, the arm member 510-2 may be disposed such that the gear portion 514-1 engages with the idle gear 440. For example, the gear portion 514-1 of the first arm member 510a-2 may engage with the first idle gear 440a and the gear portion 514-1 of the second arm member 510b-2 may engage with the second idle gear 440b. In a state in which the gear portion 514-1 engages with the idle gear 440, the gear bracket 430 may be positioned in the spacing S between the gear portion 514-1 and the cam portion 511. With this structure, instead of forming a gear structure on the shaft (e.g., the shaft 420 of FIG. 4), a gear structure may be formed on the arm member 510-2 such that the arm member 510-2 directly interoperates with the idle gear 440.

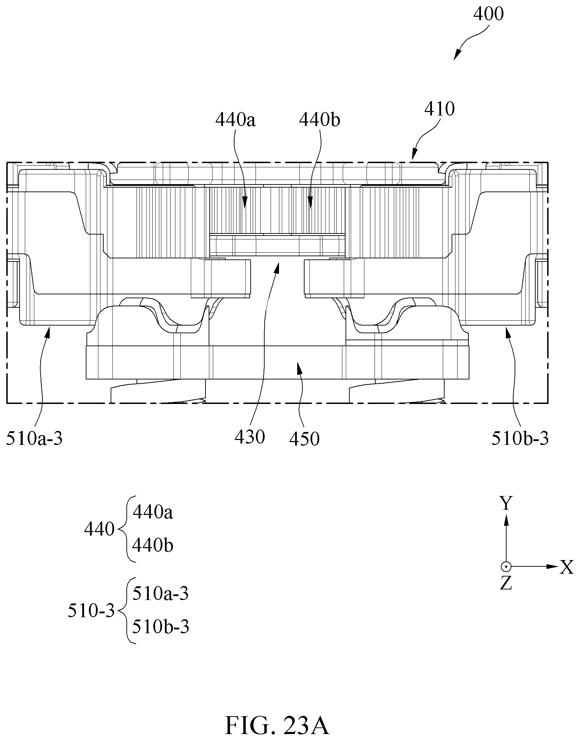

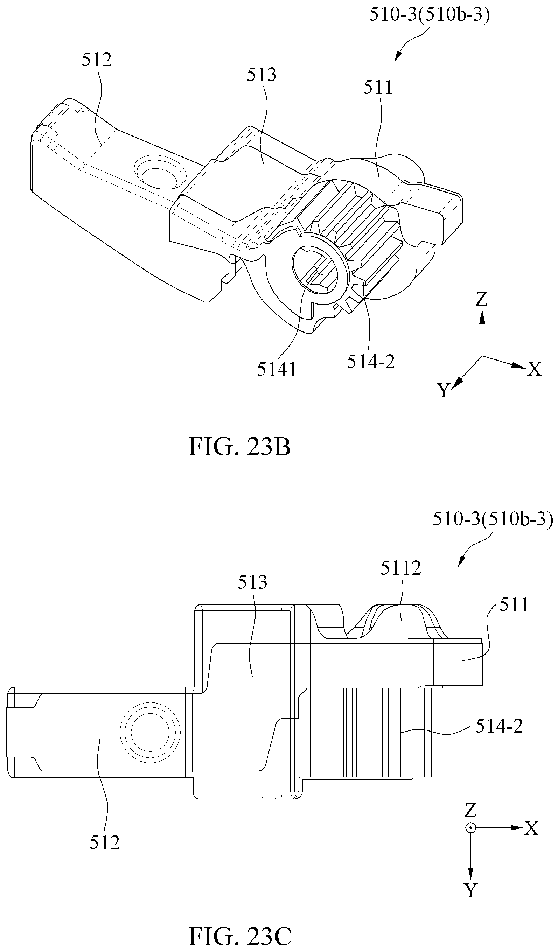

FIG. 23A is a partial front view illustrating a hinge assembly according to an embodiment. FIG. 23B is a perspective view of an arm member according to an embodiment. FIG. 23C is a plan view of the arm member according to an embodiment.

The descriptions provided with reference to FIGS. 4 to 17B may apply to the hinge assembly 400 and the arm member 510-3 described with reference to FIGS. 23A to 23C within a range that does not contradict for substantially the same configuration.

In an embodiment, the hinge assembly 400 may include the hinge bracket 410, the idle gear 440, the gear bracket 430, the arm member 510-3, and/or the cam member 450. The idle gear 440 may include a first idle gear 440a and a second idle gear 440b. The arm member 510-3 may include a first arm member 510a-3 and a second arm member 510b-3. Hereinafter, the arm member 510-3 is described based on the second arm member 510b-3. The first arm member 510a-3 may be substantially symmetrical to the second arm member 510b-3 based on a folding axis (e.g., the folding axis A of FIG. 3).

In an embodiment, the arm member 510-3 may include a cam structure and a gear structure. For example, the arm member 510-3 may include the cam portion 511, the body portion 512, the connecting portion 513, and the gear portion 514-2. The cam portion 511 may be a portion on which the cam crest 5112 is formed. The body portion 512 may be a portion to which an arm bracket (e.g., the arm bracket 520 of FIG. 4) is slidably connected. The gear portion 514-2 may be a portion having a gear structure. The gear portion 514-2 may be connected to the cam portion 511. For example, the gear portion 514-2 and the cam portion 511 may be substantially formed as one. For example, the gear portion 514-2 may be formed to be connected to a surface among the surfaces of the cam portion 511. The surface (e.g., +Y direction) on which the gear portion 514-2 is formed is opposite to the surface (e.g., -Y direction) on which the cam crest 5112 is formed. A through hole 5141 to which a shaft (e.g., the shaft 420 of FIG. 4) is inserted may be formed near the center of the gear portion 514-2. The connecting portion 513 may be a portion that connects the cam portion 511, the gear portion 514-2, and the body portion 512 to one another. The cam portion 511 and the gear portion 514-2 may be positioned on one side (e.g., the side in the +X direction) of the connecting portion 513 and the body portion 512 may be positioned at the other side (e.g., the side in the -X direction) of the connecting portion 513.

In an embodiment, the arm member 510-3 may be disposed such that the gear portion 514-2 engages with the idle gear 440. For example, the gear portion 514-2 of the first arm member 510a-3 may engage with the first idle gear 440a and the gear portion 514-2 of the second arm member 510b-3 may engage with the second idle gear 440b. When the gear portion 514-2 and the idle gear 440 engage with each other, the gear bracket 430 may be positioned in the space between the first arm member 510a-3 and the second arm member 510b-3. For example, the thickness (e.g., the thickness in the Y direction) of the gear portion 514-2 may be greater than the thickness (e.g., the thickness in the Y direction) of the idle gear 440. The gear bracket 430 may be positioned in the space between the gear portion 514-2 of the first arm member 510a-3 and the gear portion 514-2 of the second arm member 510b-3. With this structure, instead of forming a gear structure on the shaft (e.g., the shaft 420 of FIG. 4), a gear structure may be formed on the arm member 510-3 such that the arm member 510-3 directly interoperates with the idle gear 440.

In an embodiment, an electronic device 300 includes a display 250 including a first area 251, a second area 252, and a folding area 253 between the first area 251 and the second area 252, a first housing 311 configured to support the first area 251, a second housing 312 configured to support the second area 252, and a hinge assembly 400 configured to connect the first housing 311 to the second housing 312 and operate between a folded state and an unfolded state, in which the first area 251 and the second area 252 face each other in the folded state and the first area 251 and the second area 252 do not face each other in the unfolded state. The hinge assembly 400 may include a hinge bracket 410, a shaft 420 rotatably connected to the hinge bracket 410, an arm member 510 connected to the shaft 420 to rotate integrally with the shaft 420 with respect to the hinge bracket 410, a cam member 450 inserted into the shaft 420 such that cam interoperation between the arm member 510 and the cam member 450 is implemented, a pressing member 460 configured to apply pressure to the cam member 450 toward the arm member 510, and an arm bracket 520 slidably connected to the arm member 510 and connected to the first housing 311 or the second housing 312. The arm member 510 may include a cam portion 511 on which a plurality of cam crests 5112 is formed along a circumference of a through hole 5111 through which the shaft 420 passes, a body portion 512 to which the arm bracket 520 is slidably connected, and a connecting portion 513 configured to connect the cam portion 511 to the body portion 512. At least a partial area of a first cam crest 5112a among the plurality of cam crests 5112 may be positioned to be aligned with the connecting portion 513 when viewed in the direction perpendicular to the axis of the shaft 420. In this manner, the strength of the connecting portion may be reinforced to reduce the occurrence of damage to an arm member.

In an embodiment, a flat area of the first cam crest 5112a may be positioned to be aligned with the connecting portion 513 when viewed in the direction perpendicular to the axis of the shaft 420. In this manner, the strength of the connecting portion may be further reinforced to minimize the occurrence of damage to an arm member.

In an embodiment, a first cam trough 5113a and a second cam trough 5113b adjacent to both ends of the first cam crest 5112a may be positioned not to be aligned with the connecting portion 513 when viewed in the direction perpendicular to the axis of the shaft 420. Therefore, the width of the connecting portion 513 may be increased and thus, the strength of the connecting portion 513 may be further increased and the occurrence of damage to the arm member 510 may be further reduced.

In an embodiment, the first distance R1 from the center of the through hole 5111 to a first outer edge P1 of the cam portion 511 adjacent to the display 250 may be less than the second distance R2 from the center of the through hole 5111 to a second outer edge P2 of the cam portion 511 far from the display 250. In this manner, the sizes the hinge assembly 400 and the electronic device 300 including the hinge assembly 400 may be decreased.

In an embodiment, the size of a flat area of a second cam crest 5112b adjacent to the display 250 among the plurality of cam crests 5112 may be less than the size of a flat area of another cam crest 5112c. This allows for flexible configuration and usage of different cam crests to cope with various levels of the concentrated pressure.

In an embodiment, the connecting portion 513 may be positioned at or below a reference line L1 parallel to the display 250 and passing through a point on the outer edge P1 of the cam portion 511 adjacent to the display 250.

In an embodiment, a recessed portion 5131 may be formed in the connecting portion 513 to avoid interference between the connecting portion 513 and the display 250 when the electronic device 300 is in the folded state.

In an embodiment, during the transition of the electronic device 300 from the folded state to the unfolded state, when the cam portion 511 rotates in a first rotation direction, a flat area of the cam crest 5112 is inclined to be higher on a second side in a second rotation direction, which is opposite to the first rotation direction, than on a first side in the first rotation direction.

In an embodiment, the width of the cam portion 511 may be less than or equal to the width of the connecting portion 513.

In an embodiment, the hinge assembly 400 may further include an elastic member 530 positioned between the arm bracket 520 and the arm member 510 and configured to apply pressure to the body portion 512 with respect to the arm bracket 520.

In an embodiment, a groove 5122 may be formed in the body portion 512 such that the elastic member 530 is in contact with at least two areas of the body portion 512.

In an embodiment, the hinge assembly 400 may further include a wing member 610 rotatably connected to the hinge bracket 410 and a wing bracket 620 slidably connected to the wing member 610 and connected to the first housing 311 or the second housing 312.

In an embodiment, the wing member 610 may include a second recessed rail 613 to which the wing bracket 620 is slidably connected.

In an embodiment, the electronic device 300 may further include a wing plate 630 connected to the wing member 610 and configured to support the first area 251 or the second area 252 of the display 250.

In an embodiment, a first recessed rail 5121 to which the arm bracket 520 is slidably connected may be formed in the body portion 512.

In an embodiment, an electronic device 300 includes a housing 310 including a first housing 311 and a second housing 312, a display 250 accommodated in the first housing 311 and the second housing 312, and a hinge assembly 400 positioned on one surface of the display 250 and connected to the first housing 311 and the second housing 312. The hinge assembly 400 may include a wing member 610 configured to rotate around a first axis A2 and an arm member 510 configured to rotate around a second axis A2 that is different from the first axis A1. The arm member 510 may include a body portion 512, a cam portion 511 on which a cam crest 5112 is formed on a surface facing the direction parallel to the second axis A2, and a connecting portion 513 positioned between the body portion 512 and the cam portion 511 and having a thickness that is less than the thickness of the body portion 512 and the thickness of the cam portion 511. The cam crest 5112 may be positioned to be aligned with the connecting portion 513 in the direction perpendicular to the second axis in an area adjacent to the connecting portion 513 within the surface of the cam portion 511. In this manner, the strength of the connecting portion may be reinforced to reduce the occurrence of damage to an arm member.

In an embodiment, the cam crest 5112 may include a flat area. The entirety of the flat area may be positioned to overlap the connecting portion 513 when viewed in the direction perpendicular to the second axis A2. In this manner, the strength of the connecting portion may be further reinforced to minimize the occurrence of damage to an arm member.

In an embodiment, a first cam trough 5113a and a second cam trough 5113b, which are adjacent to both ends of the cam crest 5112, may be formed in the surface of the cam portion 511. Each of the first cam trough 5113a and the second cam trough 5113b may be positioned not to overlap the connecting portion 513 when viewed in the direction perpendicular to the second axis A2.

In an embodiment, during the transition of the electronic device 300 from a folded state to an unfolded state, the cam portion 511 may rotate around the second axis A2 in a first rotation direction. A flat area of the cam crest 5112 may be inclined to be higher on a second side in a second rotation direction, which is opposite to the first rotation direction, than on a first side in the first rotation direction.

In an embodiment, the width of the cam portion 511 may be less than or equal to the width of the connecting portion 513.

## Claims

1. An electronic device (300) comprising:
a display (250) comprising a first area (251), a second area (252), and a folding area (253) between the first area (251) and the second area (252);
a first housing (311) configured to support the first area (251);
a second housing (312) configured to support the second area (252); and
a hinge assembly (400) configured to connect the first housing (311) to the second housing (312) and operate between a folded state and an unfolded state, in which the first area (251) and the second area (252) face each other in the folded state and the first area (251) and the second area (252) do not face each other in the unfolded state,
wherein the hinge assembly (400) comprises:
a hinge bracket (410);
a shaft (420) rotatably connected to the hinge bracket (410);
an arm member (510) connected to the shaft (420) to rotate integrally with the shaft (420) with respect to the hinge bracket (410);
a cam member (450) inserted into the shaft (420) such that cam interoperation between the arm member (510) and the cam member (450) is implemented;
a pressing member (460) configured to apply pressure to the cam member (450) toward the arm member (510); and
an arm bracket (520) slidably connected to the arm member (510) and connected to the first housing (311) or the second housing (312),
wherein the arm member (510) comprises:
a cam portion (511) on which a plurality of cam crests (5112) is formed along a circumference of a through hole (5111) through which the shaft (420) passes;
a body portion (512) to which the arm bracket (520) is slidably connected; and
a connecting portion (513) configured to connect the cam portion (511) to the body portion (512), and
wherein at least a partial area of a first cam crest (5112a) among the plurality of cam crests (5112) is positioned to be aligned with the connecting portion (513) when viewed in a direction perpendicular to an axis of the shaft (420),
**characterized in that** a first distance (R1) from a center of the through hole (5111) to a first outer edge (P1) of the cam portion (511) adjacent to the display (250) is less than a second distance (R2) from the center of the through hole (5111) to a second outer edge (P2) of the cam portion (511) far from the display (250).

2. The electronic device (300) of claim 1, wherein a flat area of the first cam crest (5112a) is positioned to be aligned with the connecting portion (513) when viewed in the direction perpendicular to the axis of the shaft (420).

3. The electronic device (300) of claim 1 or 2, wherein a first cam trough (5113a) and a second cam trough (5113b) adjacent to both ends of the first cam crest (5112a) are positioned not to be aligned with the connecting portion (513) when viewed in the direction perpendicular to the axis of the shaft (420).

4. The electronic device (300) of one of claims 1 to 3, wherein a size of a flat area of a second cam crest (5112b) adjacent to the display (250) among the plurality of cam crests (5112) is less than a size of a flat area of another cam crest (5112c).

5. The electronic device (300) of one of claims 1 to 4, wherein the connecting portion (513) is positioned at or below a reference line (L1) parallel to the display (250) and passing through a point on the outer edge (P1) of the cam portion (511) adjacent to the display (250).

6. The electronic device (300) of one of claims 1 to 5, wherein a recessed portion (5131) is formed in the connecting portion (513) to avoid interference between the connecting portion (513) and the display (250) when the electronic device (300) is in the folded state.

7. The electronic device (300) of one of claims 1 to 6, wherein, during a transition of the electronic device (300) from the folded state to the unfolded state, when the cam portion (511) rotates in a first rotation direction, a flat area of the cam crest (5112) is inclined to be higher on a second side in a second rotation direction, which is opposite to the first rotation direction, than on a first side in the first rotation direction.

8. The electronic device (300) of one of claims 1 to 7, wherein a width of the cam portion (511) is less than or equal to a width of the connecting portion (513).

9. The electronic device (300) of one of claims 1 to 8, wherein the hinge assembly (440) further comprises an elastic member (530) positioned between the arm bracket (520) and the arm member (510) and configured to apply pressure to the body portion (512) with respect to the arm bracket (520).

10. The electronic device (300) of claim 9, wherein a groove (5122) is formed in the body portion (512) such that the elastic member (530) is in contact with the body portion (512) in at least two areas.

11. The electronic device (300) of one of claims 1 to 10, wherein the hinge assembly (400) further comprises:
a wing member (610) rotatably connected to the hinge bracket (410); and
a wing bracket (620) slidably connected to the wing member (610) and connected to the first housing (311) or the second housing (312).

12. The electronic device (300) of claim 11, wherein the wing member (610) comprises a second recessed rail (613) to which the wing bracket (620) is slidably connected.

13. The electronic device (300) of claim 11 or 12, further comprising:
a wing plate (630) connected to the wing member (610) and configured to support the first area (251) or the second area (252) of the display (250).

14. The electronic device (300) of one of claims 1 to 13, wherein a first recessed rail (5121) to which the arm bracket (520) is slidably connected is formed in the body portion (512).

## Patentansprüche

1. Elektronische Vorrichtung (300), umfassend:
eine Anzeige (250), umfassend einen ersten Bereich (251), einen zweiten Bereich (252), und einen Faltbereich (253) zwischen dem ersten Bereich (251) und dem zweiten Bereich (252);
ein erstes Gehäuse (311), das so konfiguriert ist, dass es den ersten Bereich (251) unterstützt;
ein zweites Gehäuse (312), das so konfiguriert ist, dass es den zweiten Bereich (252) unterstützt; und
eine Scharnieranordnung (400), die konfiguriert ist, um das erste Gehäuse (311) mit dem zweiten Gehäuse (312) zu verbinden und zwischen einem gefalteten Zustand und einem entfalteten Zustand zu arbeiten, wobei der erste Bereich (251) und der zweite Bereich (252) einander in dem gefalteten Zustand zugewandt sind und der erste Bereich (251) und der zweite Bereich (252) einander in dem entfalteten Zustand nicht zugewandt sind,
wobei die Scharnieranordnung (400) umfasst:
eine Scharnierhalterung (410);
eine Welle (420), die drehbar mit der Scharnierhalterung (410) verbunden ist;
ein Armelement (510), das mit der Welle (420) verbunden ist, um sich integral mit der Welle (420) in Bezug auf die Scharnierhalterung (410) zu drehen;
ein Nockenelement (450), das in die Welle (420) eingesetzt ist, so dass ein Zusammenwirken des Nockens zwischen dem Armelement (510) und dem Nockenelement (450) realisiert wird;
ein Drückelement (460), das konfiguriert ist, um Druck auf das Nockenelement (450) in Richtung des Armelements (510) auszuüben; und
eine Armhalterung (520), die gleitend mit dem Armelement (510) verbunden ist und mit dem ersten Gehäuse (311) oder dem zweiten Gehäuse (312) verbunden ist, wobei das Armelement (510) umfasst:
einen Nockenabschnitt (511), an dem eine Vielzahl von Nockenkämmen (5112) entlang eines Umfangs eines Durchgangslochs (5111) ausgebildet ist, durch das die Welle (420) verläuft;
einen Körperabschnitt (512), mit dem die Armhalterung (520) gleitend verbunden ist; und
einen Verbindungsabschnitt (513), der konfiguriert ist, um den Nockenabschnitt (511) mit dem Körperabschnitt (512) zu verbinden, und
wobei zumindest ein Teilbereich eines ersten Nockenkamms (5112a) aus der Vielzahl von Nockenkämmen (5112) so positioniert ist, dass er mit dem Verbindungsabschnitt (513) ausgerichtet ist, wenn er in einer Richtung senkrecht zu einer Achse der Welle (420) betrachtet wird,
**dadurch gekennzeichnet, dass** ein erster Abstand (R1) von einer Mitte des Durchgangslochs (5111) zu einer ersten Außenkante (P1) des Nockenabschnitts (511) in der Nähe der Anzeige (250) kleiner ist als ein zweiter Abstand (R2) von der Mitte des Durchgangslochs (5111) zu einer zweiten Außenkante (P2) des Nockenabschnitts (511), die von der Anzeige (250) entfernt ist.

2. Elektronische Vorrichtung (300) nach Anspruch 1, wobei ein flacher Bereich des ersten Nockenkamms (5112a) so positioniert ist, dass er mit dem Verbindungsabschnitt (513) ausgerichtet ist, wenn er in der Richtung senkrecht zur Achse der Welle (420) betrachtet wird.

3. Elektronische Vorrichtung (300) nach Anspruch 1 oder 2, wobei eine erste Nockenmulde (5113a) und eine zweite Nockenmulde (5113b), die an beide Enden des ersten Nockenkamms (5112a) angrenzen, so positioniert sind, dass sie bei Betrachtung in Richtung senkrecht zur Achse der Welle (420) nicht mit dem Verbindungsabschnitt (513) ausgerichtet sind.

4. Elektronische Vorrichtung (300) nach einem der Ansprüche 1 bis 3, wobei eine Größe eines flachen Bereichs eines zweiten Nockenkamms (5112b) neben der Anzeige (250) unter der Vielzahl von Nockenkämmen (5112) kleiner ist als eine Größe eines flachen Bereichs eines anderen Nockenkamms (5112c).

5. Elektronische Vorrichtung (300) nach einem der Ansprüche 1 bis 4, wobei der Verbindungsabschnitt (513) an oder unterhalb einer parallel zur Anzeige (250) verlaufenden Bezugslinie (L1) positioniert ist, die durch einen Punkt an der Außenkante (P1) des Nockenabschnitts (511) neben der Anzeige (250) verläuft.

6. Elektronische Vorrichtung (300) nach einem der Ansprüche 1 bis 5, wobei in dem Verbindungsabschnitt (513) ein ausgesparter Abschnitt (5131) ausgebildet ist, um eine Störung zwischen dem Verbindungsabschnitt (513) und der Anzeige (250) zu vermeiden, wenn sich die elektronische Vorrichtung (300) im gefalteten Zustand befindet.

7. Elektronische Vorrichtung (300) nach einem der Ansprüche 1 bis 6, wobei während eines Übergangs der elektronischen Vorrichtung (300) vom gefalteten Zustand in den entfalteten Zustand, wenn sich der Nockenabschnitt (511) in einer ersten Drehrichtung dreht, ein flacher Bereich des Nockenkamms (5112) so geneigt ist, dass er auf einer zweiten Seite in einer zweiten Drehrichtung, die der ersten Drehrichtung entgegengesetzt ist, höher liegt als auf einer ersten Seite in der ersten Drehrichtung.

8. Elektronische Vorrichtung (300) nach einem der Ansprüche 1 bis 7, wobei die Breite des Nockenabschnitts (511) kleiner oder gleich einer Breite des Verbindungsabschnitts (513) ist.

9. Elektronische Vorrichtung (300) nach einem der Ansprüche 1 bis 8, wobei die Scharnieranordnung (440) ferner ein elastisches Element (530) umfasst, das zwischen der Armhalterung (520) und dem Armelement (510) positioniert und so konfiguriert ist, dass es Druck auf den Körperabschnitt (512) in Bezug auf die Armhalterung (520) ausübt.

10. Elektronische Vorrichtung (300) nach Anspruch 9, wobei eine Nut (5122) in dem Körperabschnitt (512) ausgebildet ist, so dass das elastische Element (530) in mindestens zwei Bereichen in Kontakt mit dem Körperabschnitt (512) ist.

11. Elektronische Vorrichtung (300) nach einem der Ansprüche 1 bis 10, wobei die Scharnieranordnung (400) ferner umfasst:
ein Flügelelement (610), das drehbar mit der Scharnierhalterung (410) verbunden ist; und
eine Flügelhalterung (620), die gleitend mit dem Flügelelement (610) verbunden ist und mit dem ersten Gehäuse (311) oder dem zweiten Gehäuse (312) verbunden ist.

12. Elektronische Vorrichtung (300) nach Anspruch 11, wobei das Flügelelement (610) eine zweite Einbauschiene (613) umfasst, mit der die Flügelhalterung (620) gleitend verbunden ist.

13. Elektronische Vorrichtung (300) nach Anspruch 11 oder 12, ferner umfassend:
eine Flügelplatte (630), die mit dem Flügelelement (610) verbunden und konfiguriert ist, um den ersten Bereich (251) oder den zweiten Bereich (252) der Anzeige (250) zu unterstützen.

14. Elektronische Vorrichtung (300) nach einem der Ansprüche 1 bis 13, wobei in dem Körperabschnitt (512) eine erste Einbauschiene (5121) ausgebildet ist, mit der die Armhalterung (520) gleitend verbunden ist.

## Revendications

1. Dispositif électronique (300), comprenant :
un affichage (250) comprenant une première zone (251), une seconde zone (252), et une zone de pliage (253) entre la première zone (251) et la seconde zone (252) ;
un premier boîtier (311) configuré pour prendre en charge la première zone (251) ;
un second boîtier (312) configuré pour prendre en charge la seconde zone (252) ; et
un ensemble de charnière (400) configuré pour connecter le premier boîtier (311) au second boîtier (312) et opérer entre un état plié et un état déplié, la première zone (251) et la seconde zone (252) se faisant face à l'état plié et la première zone (251) et la seconde zone (252) ne se faisant pas face à l'état déplié,
dans lequel l'ensemble de charnière (400) comprend :
un support de charnière (410) ;
un arbre (420) relié de manière rotative au support de charnière (410) ;
un élément de bras (510) relié à l'arbre (420) pour tourner intégralement avec l'arbre (420) par rapport au support de charnière (410) ;
un élément de came (450) inséré dans l'arbre (420) de sorte que l'interopérabilité de came entre l'élément de bras (510) et l'élément de came (450) soit mise en œuvre ;
un élément de pression (460) configuré pour appliquer une pression sur l'élément de came (450) en direction de l'élément de bras (510) ; et
un support de bras (520) relié de manière coulissante à l'élément de bras (510) et relié au premier boîtier (311) ou au second boîtier (312),
dans lequel l'élément de bras (510) comprend :
une partie de came (511) sur laquelle une pluralité de crêtes de came (5112) est formée le long d'une circonférence d'un trou traversant (5111) à travers lequel passe l'arbre (420) ;
une partie de corps (512) à laquelle le support de bras (520) est relié de manière coulissante ; et
une partie de connexion (513) configurée pour connecter la partie de came (511) à la partie de corps (512), et
dans lequel au moins une zone partielle d'un premier crête de came (5112a) parmi la pluralité de crêtes de came (5112) est positionnée pour être alignée avec la partie de connexion (513) lorsqu'elle est vue dans une direction perpendiculaire à un axe de l'arbre (420),
**caractérisé en ce qu'**une première distance (R1) entre un centre du trou traversant (5111) et un premier bord extérieur (P1) de la partie de came (511) adjacente à l'affichage (250) est inférieure à une seconde distance (R2) entre le centre du trou traversant (5111) et un second bord extérieur (P2) de la partie de came (511) éloignée de l'affichage (250).

2. Dispositif électronique (300) de la revendication 1, dans lequel une zone plate du premier crête de came (5112a) est positionnée pour être alignée avec la partie de connexion (513) lorsqu'elle est vue dans la direction perpendiculaire à l'axe de l'arbre (420).

3. Dispositif électronique (300) de la revendication 1 ou 2, dans lequel un premier creux de came (5113a) et un second creux de came (5113b) adjacents aux deux extrémités du premier crête de came (5112a) sont positionnés de manière à ne pas être alignés avec la partie de connexion (513) lorsqu'ils sont vus dans la direction perpendiculaire à l'axe de l'arbre (420).

4. Dispositif électronique (300) de l'une des revendications 1 à 3, dans lequel une taille d'une zone plate d'un second crête de came (5112b) adjacent à l'affichage (250) parmi la pluralité de crêtes de came (5112) est inférieure à une taille d'une zone plate d'un autre crête de came (5112c).

5. Dispositif électronique (300) de l'une des revendications 1 à 4, dans lequel la partie de connexion (513) est positionnée au niveau ou en dessous d'une ligne de référence (L1) parallèle à l'affichage (250) et passant par un point du bord extérieur (P1) de la partie de came (511) adjacente à l'affichage (250).

6. Dispositif électronique (300) de l'une des revendications 1 à 5, dans lequel une partie évidée (5131) est formée dans la partie de connexion (513) pour éviter les interférences entre la partie de connexion (513) et l'affichage (250) lorsque le dispositif électronique (300) est à l'état plié.

7. Dispositif électronique (300) de l'une des revendications 1 à 6, dans lequel, lors d'une transition du dispositif électronique (300) de l'état plié à l'état déplié, lorsque la partie de came (511) tourne dans un premier sens de rotation, une zone plate de la crête de came (5112) est inclinée pour être plus haute sur un second côté dans un second sens de rotation, qui est opposé au premier sens de rotation, que sur un premier côté dans le premier sens de rotation.

8. Dispositif électronique (300) de l'une des revendications 1 à 7, dans lequel la largeur de la partie de came (511) est inférieure ou égale à la largeur de la partie de connexion (513).

9. Dispositif électronique (300) de l'une des revendications 1 à 8, dans lequel l'ensemble de charnière (440) comprend en outre un élément élastique (530) positionné entre le support de bras (520) et l'élément de bras (510) et configuré pour appliquer une pression sur la partie de corps (512) par rapport au support de bras (520).

10. Dispositif électronique (300) de la revendication 9, dans lequel une rainure (5122) est formée dans la partie de corps (512) de sorte que l'élément élastique (530) est en contact avec la partie de corps (512) dans au moins deux zones.

11. Dispositif électronique (300) de l'une des revendications 1 à 10, dans lequel l'ensemble de charnière (400) comprend en outre :
un élément d'aile (610) relié de manière rotative au support de charnière (410) ; et
un support d'aile (620) relié de manière coulissante à l'élément d'aile (610) et relié au premier boîtier (311) ou au second boîtier (312).

12. Dispositif électronique (300) de la revendication 11, dans lequel l'élément d'aile (610) comprend un second rail évidé (613) auquel le support d'aile (620) est relié de manière coulissante.

13. Dispositif électronique (300) de la revendication 11 ou 12, comprenant en outre :
une plaque d'aile (630) reliée à l'élément d'aile (610) et configurée pour prendre en charge la première zone (251) ou la seconde zone (252) de l'affichage (250).

14. Dispositif électronique (300) de l'une des revendications 1 à 13, dans lequel un premier rail évidé (5121) auquel le support de bras (520) est connecté de manière coulissante est formé dans la partie de corps (512).
